# EUROPEAN PATENT APPLICATION

(11) **EP 4 506 491 A1**
(43) Date of publication of application: **12.02.2025**
(21) Application number: 23811106.6
(22) Date of filing: 24.05.2023
(51) Int. Cl.: C30B 11/00, C30B 19/00, C30B 29/36

(54) **CONNECTING DEVICE**

(30) Priority: 27.05.2022 CN 202210584906; 31.05.2022 CN 202210605500
(71) Applicant: MEISHAN BOYA ADVANCED MATERIALS CO., LTD., Meishan, Sichuan 620010 (CN)
(72) Inventor: WANG, Yu, Meishan, Sichuan 620010 (CN); GU, Peng, Meishan, Sichuan 620010 (CN); GUAN, Weiming, Meishan, Sichuan 620010 (CN); YE, Shuai, Meishan, Sichuan 620010 (CN); WU, Ge, Meishan, Sichuan 620010 (CN)
(74) Representative: Wang, Bo
(86) International application number: PCT/CN2023/096100
(87) International publication number: WO 2023/227036

(57) **Abstract**

Embodiments of the present description provide a connecting device. The device comprises a seed crystal support and a seed crystal rod, and the seed crystal support is connected to one end of the seed crystal rod.

## Description

### CROSS-REFERENCE TO RELATED APPLICATIONS

This application is a continuation of International Patent Application No. PCT/CN2023/096100, filed on May 24, 2023, which claims priority of Chinese Patent Application No. 202210584906.7, filed on May 27, 2022, and Chinese Patent Application No. 202210605500.2, filed on May 31, 2022, the entire contents of each of which are hereby incorporated by reference.

### TECHNICAL FIELD

The present disclosure relates to the field of crystal preparation technology, and in particular, to connecting devices for growing crystals based on a liquid phase technique.

### BACKGROUND

The liquid phase technique is one of the methods used to grow crystals (e.g., silicon carbide single crystals). When growing crystals using the liquid phase technique, a connecting device is required to connect a seed crystal and rotate the seed crystal to grow a crystal. In order to ensure the quality of crystal growth, it is often necessary to improve the connecting device. Therefore, it is desirable to provide an improved connecting device to ensure crystal growth quality.

### SUMMARY

One of the embodiments of the present disclosure provides a connecting device. The device may include a seed crystal support and a seed crystal rod. The seed crystal support may be connected to one end of the seed crystal rod.

In some embodiments, the connecting device may further include a leveling assembly. The leveling assembly may be connected to another end of the seed crystal rod for leveling the seed crystal rod. The leveling assembly may include a supporting member, a connecting member and an adjusting locking member. The connecting member may be movably disposed on the supporting member, and one end of the connecting member is connected to another end of the seed crystal rod. The adjusting locking member may be disposed on the supporting member for adjusting and locking a position of the connecting member relative to the supporting member.

In some embodiments, the connecting member may include a connecting sphere and an adjusting sphere. The connecting sphere may be movably abutted against the supporting member. The adjusting locking member may contact the adjusting sphere.

In some embodiments, the adjusting locking member may include an upper locking block, an adjusting lever, and a locking lever. The upper locking block may be provided above the adjusting sphere for applying a locking force that is vertical downward to the connecting member. The adjusting lever and the locking lever may be disposed opposite each other on two sides of the adjusting sphere and contact a surface of the adjusting sphere.

In some embodiments, the adjusting sphere may include an upper hemisphere and a lower hemisphere, and the adjusting lever and the locking lever may contact the upper hemisphere and the lower hemisphere, respectively.

In some embodiments, the upper hemisphere and the lower hemisphere may have different diameters.

In some embodiments, the adjusting locking member may further include an annular guide rail, an annular slider, an adjusting lever pillar, and a locking lever pillar. The annular guide rail may be provided on the supporting member, and the annular slider may rotate relative to the annular guide rail by cooperating with the annular guide rail. The adjusting lever may be provided on the adjusting lever pillar, the locking lever may be set on the locking lever pillar, and the adjusting lever pillar and the locking lever pillar may be provided opposite each other on the annular slider.

In some embodiments, at least one of the adjusting lever or the locking lever may be in a line contact or a surface contact with the adjusting sphere.

In some embodiments, the connecting device may further include a protection assembly. The protection assembly may be connected to the seed crystal support and may cover an edge and an upper surface of the seed crystal support.

In some embodiments, the seed crystal support may include a cylindrical portion and a truncated cone portion connected with the cylindrical portion.

In some embodiments, the protection assembly may include an annular portion, a connecting portion, and a fixing portion, the fixing portion may be provided in the connecting portion, and the annular portion is provided at an edge of the connecting portion. The annular portion may contact an outer periphery of the cylindrical portion. The connecting portion may contact an outer periphery and an upper surface of the truncated cone portion.

In some embodiments, the one end of the seed crystal support may include an external thread. The fixing portion may include a first internal thread that mates with the internal thread.

In some embodiments, the seed crystal may be provided with a second internal thread that mates with the external thread, and the one end of the seed crystal rod may be threadedly connected to the seed crystal support and the fixing portion.

In some embodiments, the protection assembly may further include a key, and a keyway that fits into the key may be provided on the seed crystal support and the fixing portion.

In some embodiments, the annular portion may be provided with a chamfer.

In some embodiments, a thickness of the connecting portion near a center of the connecting portion may be greater than a thickness of an edge portion of the connecting portion.

In some embodiments, materials of the annular portion and the connecting portion may be boron nitride.

In some embodiments, a count of the seed crystal rod may be at least one, a count of connection points connecting the at least one seed crystal rod and the seed crystal support may be greater than or equal to 2, and the connection points do not coincide with a rotation center of the seed crystal support.

In some embodiments, the connection points may be uniformly distributed along a circumference of the seed crystal support.

In some embodiments, the seed crystal support may be in a slot connection with the at least one seed crystal rod.

In some embodiments, the slot connection may include a connecting block and a connecting groove adapted to the connecting block. The connecting groove may be provided on the seed crystal rod, and the connecting block may be provided on the seed crystal support.

In some embodiments, the connecting device may further include a connecting ring, and the connecting ring may be threadedly connected to the seed crystal rod provided with the connecting groove.

In some embodiments, the seed crystal support may be in a threaded connection with the at least one seed crystal rod.

In some embodiments, the seed crystal support may be connected to at least two seed crystal rods.

In some embodiments, the seed crystal support may be connected to one seed crystal rod via at least two connecting pins.

In some embodiments, one of the at least two connecting pins may include a connecting groove and a connecting ring. The connecting groove may be mutually adapted with a connecting block provided on the seed crystal support, and the connecting ring may be connected to an outer wall of the one of the at least two connecting pins by threads.

In some embodiments, the at least one seed crystal rod may include a plurality of connecting segments, and connection points between the plurality of the connecting segments does not coincide with a rotation center of the seed crystal support.

In some embodiments, the seed crystal support may include at least a portion of a heat dissipation structure.

In some embodiments, the heat dissipation structure may include a stepped-raised structure with a thick center and thin edges.

In some embodiments, the heat dissipation structure may include a conical raised structure with a high center and low edges.

In some embodiments, the heat dissipation structure may include at least one horizontal through hole within the seed crystal support.

In some embodiments, the seed crystal support may be connected to the seed crystal rod through a center vertical hole, and the at least one horizontal through hole may be connected to the center vertical hole.

In some embodiments, the heat dissipation structure may include at least one vertical through hole within the seed crystal support.

In some embodiments, a size of the at least one vertical through hole may decrease progressively from a center to edges of the seed crystal support.

In some embodiments, the heat dissipation structure may include at least one horizontal through hole and at least one vertical through hole within the seed crystal support.

In some embodiments, the at least one horizontal through hole may be connected to the at least one vertical through hole.

In some embodiments, the seed crystal rod may be a hollow structure.

### BRIEF DESCRIPTION OF THE DRAWINGS

The present disclosure is further illustrated in terms of exemplary embodiments. These exemplary embodiments are described in detail with reference to the drawings. These embodiments are non-limiting exemplary embodiments, in which like reference numerals represent similar structures, and wherein:
FIG. 1 is a schematic diagram illustrating an exemplary connecting device according to some embodiments of the present disclosure;
FIG. 2 is a schematic diagram illustrating an exemplary leveling assembly according to some embodiments of the present disclosure;
FIG. 3A is a localized enlarged view of region A in FIG.2;
FIG. 3B is a top view of a lower connecting block;
FIG. 4 is a schematic diagram illustrating an exemplary seed crystal support and a protection assembly according to some other embodiments of the present disclosure;
FIG. 5 is a schematic diagram illustrating an exemplary protection assembly according to some embodiments of the present disclosure;
FIG. 6 is a schematic diagram illustrating an exemplary protection assembly according to some other embodiments of the present disclosure;
FIG. 7 is a schematic diagram illustrating an exemplary seed crystal support according to some other embodiments of the present disclosure;
FIG. 8 is a side view of an exemplary connecting device according to some embodiments of the present disclosure;
FIGs. 9A-9C are schematic diagrams illustrating a distribution of exemplary connection points according to some embodiments of the present disclosure;
FIGs. 10A-10B are schematic diagrams illustrating a slot connection between a seed crystal support and at least one seed crystal rod according to some embodiments of the present disclosure;
FIGs. 11A-11F are schematic diagrams illustrating an exemplary connecting block according to some embodiments of the present disclosure;
FIG. 12 is a schematic diagram illustrating a connection process of a seed crystal support being connected with a seed crystal rod via a slot connection according to some embodiments of the present disclosure;
FIG. 13 is a schematic diagram illustrating a connection process of a seed crystal support being threadedly connected to a seed crystal rod according to some embodiments of the present disclosure;
FIG. 14 is a schematic diagram illustrating a connection between a seed crystal support and at least two seed crystal rods according to some embodiments of the present disclosure;
FIG. 15 is a schematic diagram illustrating a connection between a seed crystal support and a seed crystal rod via at least two connecting pins according to some embodiments of the present disclosure;
FIG. 16 is a schematic diagram illustrating an exemplary crystal preparation apparatus according to some embodiments of the present disclosure;
FIG. 17A is a side view of an exemplary seed crystal support according to some embodiments of the present disclosure;
FIG. 17B is a side view of another exemplary seed crystal support according to some embodiments of the present disclosure;
FIG. 17C is a top view of a cross section of an exemplary seed crystal support according to some embodiments of the present disclosure;
FIG. 17D is a top view of a cross section of an exemplary seed crystal support according to yet another embodiment of the present disclosure;
FIG. 17E is a top view of a cross section of an exemplary seed crystal support according to yet another embodiment of the present disclosure;
FIG. 18 is a schematic diagram illustrating an exemplary crystal prepared using a conventional seed crystal support according to some embodiments of the present disclosure;
FIG. 19A is a schematic diagram illustrating an exemplary connecting device according to some embodiments of the present disclosure;
FIG. 19B is a main view of a crystal grown according to Example 1 of the present disclosure;
FIG. 20A is a schematic diagram illustrating an exemplary connecting device according to yet another embodiment of the present disclosure;
FIG. 20B is a main view of a crystal grown according to Example 2 of the present disclosure;
FIG. 21A is a schematic diagram illustrating an exemplary connecting device according to yet another embodiment of the present disclosure;
FIG. 21B is a main view of a crystal grown according to Example 3 of the present disclosure;
FIG. 21C is a main view of a crystal grown according to Example 3 of the present disclosure;
FIG. 22A is a schematic diagram illustrating an exemplary connecting device according to yet another embodiment of the present disclosure; and
FIG. 22B is a main view of a crystal grown according to Example 4 of the present disclosure.

In the figure: 10 is a crystal preparation apparatus, 100 is a connecting device, 110 is a seed crystal support, 111 is a second internal thread, 112 is a cylindrical portion, 113 is a truncated cone portion, 114 is a rotation center, 115 is a connection point, 116 is a connecting block, 117 is a stepped-raised structure, 118 is a conical raised structure, 119 is a horizontal through hole, 1110 is a center vertical hole, 1111 is a vertical through hole, 120 is a seed crystal rod, 121 is a connecting groove, 130 is a leveling assembly, 131 is a supporting member, 1311 is an upper connecting block, 1312 is a lower connecting block, 1313 is a connecting rod, 132 is a connecting member, and 1321 is a connecting sphere, 1322 is an adjusting sphere, 13221 is an upper hemisphere, 13222 is a lower hemisphere, 1331 is an upper locking block, 1332 is an adjusting lever, 13321 is an adjusting ball, 1333 is a locking lever, 13331 is a locking ball, 1341 is an annular guide rail, 13411 is an outer ring, 13412 is an inner ring, 1342 is an annular slider, 1343 is an adjusting lever pillar, 1344 is a locking lever pillar, 1345 is a locking nut, 1346 is a threaded section, 140 is a protection assembly, 141 is an annular portion, 142 is a connecting portion, 143 is a fixing portion, 144 is a first internal thread, 145 is a chamfer, 146 is an avoidance groove, 150 is a connecting ring, 160 is a drive connecting member, 170 is a connecting pin, 200 is a growth cavity, and 220 is a source material.

### DETAILED DESCRIPTION

To more clearly illustrate the technical solutions related to the embodiments of the present disclosure, a brief introduction of the drawings referred to the description of the embodiments is provided below. Obviously, the drawings described below are only some examples or embodiments of the present disclosure. Those having ordinary skills in the art, without further creative efforts, may apply the present disclosure to other similar scenarios according to these drawings. Unless obviously obtained from the context or the context illustrates otherwise, the same numeral in the drawings refers to the same structure or operation.

It should be understood that "system", "device", "unit" and/or "module" as used herein is a manner used to distinguish different components, elements, parts, sections, or assemblies at different levels. However, if other words serve the same purpose, the words may be replaced by other expressions.

As shown in the present disclosure and claims, the words "one", "a", "a kind" and/or "the" are not especially singular but may include the plural unless the context expressly suggests otherwise. In general, the terms "comprise", "comprises", "comprising", "include", "includes", and/or "including", merely prompt to include operations and elements that have been clearly identified, and these operations and elements do not constitute an exclusive listing. The methods or devices may also include other operations or elements.

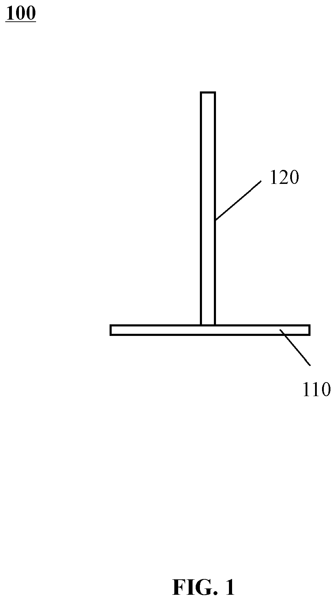

FIG. 1 is a schematic diagram illustrating an exemplary connecting device according to some embodiments of the present disclosure.

As shown in FIG. 1, a connecting device 100 may include a seed crystal support 110 and a seed crystal rod 120.

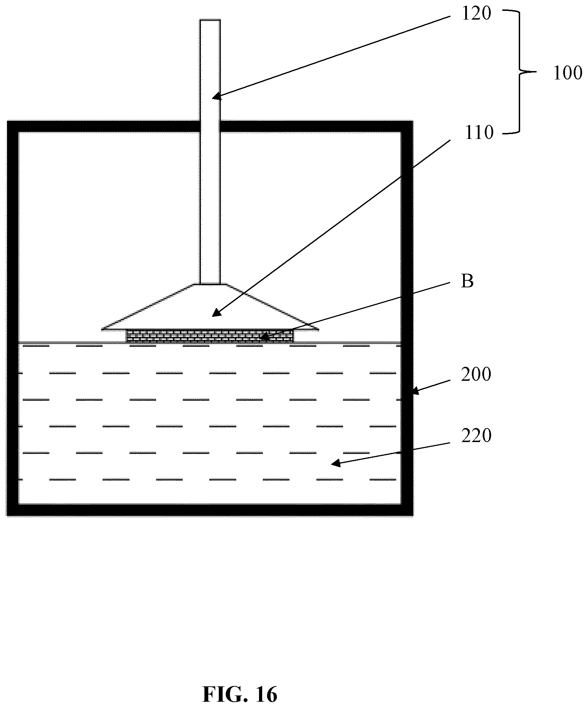

The seed crystal support 110 may be configured to bond a seed crystal. In some embodiments, the seed crystal support 110 may be a rotary structure. In some embodiments, the seed crystal support 110 may be a disk-type or a truncated cone-type, etc., or a combination thereof. Descriptions regarding the seed crystal support 110 may be found elsewhere in the present disclosure (e.g., FIG. 16, FIGs. 17A-FIG. 17E, FIG. 19A, FIG. 20A, FIG. 21A, FIG. 22A, and related descriptions thereof) and may not be repeated herein.

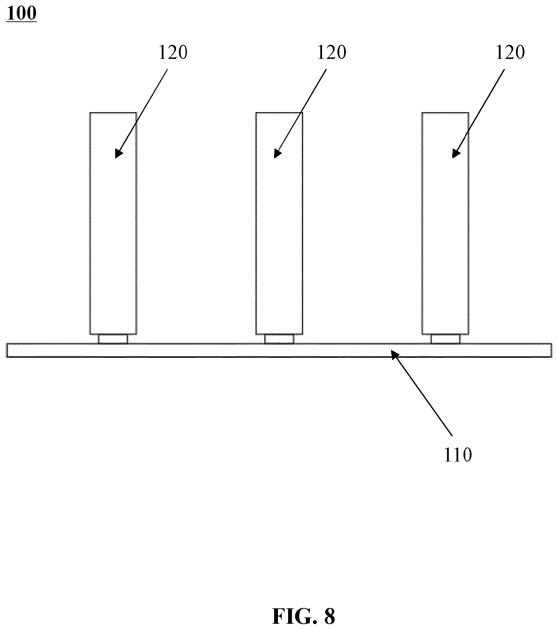

An end of the seed crystal rod 120 may be connected (e.g., fixedly connected or detachably connected) with the seed crystal support 110. By controlling the seed crystal rod 120 to move and/or rotate, the seed crystal rod120 may move and/or rotate the seed crystal support 110 to grow a crystal. In some embodiments, the seed crystal rod 120 may be cylindrical. In some embodiments, the count of the seed crystal rod 120 may be at least one. In some embodiments, the seed crystal rod 120 and the seed crystal support 110 may be coaxial or non-coaxial. Descriptions regarding the seed crystal rod 120 may be found elsewhere in the present disclosure (e.g., FIG. 8, FIG. 10A, FIGs. 12-FIG. 15 and related descriptions thereof) and may not be repeated here.

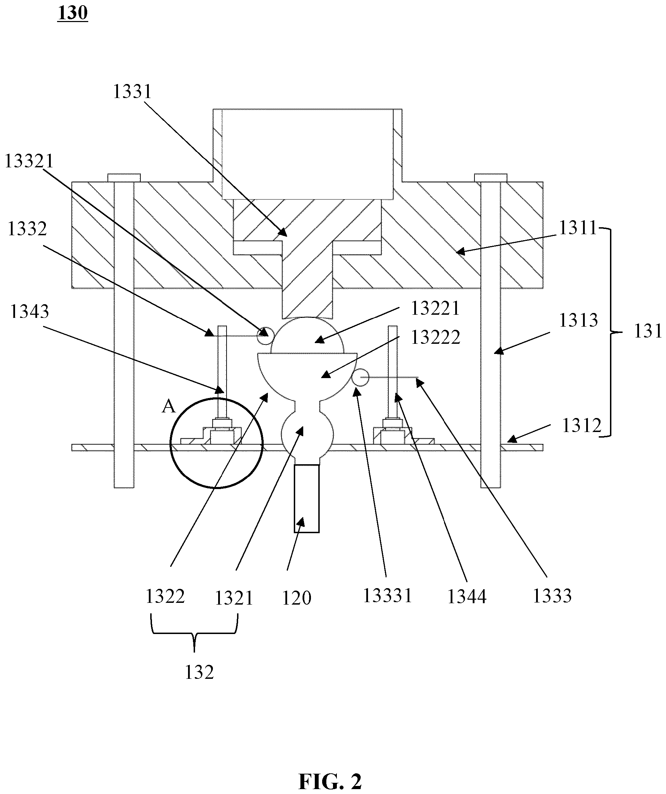

FIG. 2 is a schematic diagram illustrating an exemplary leveling assembly according to some embodiments of the present disclosure.

As shown in FIG. 2, the connecting device 100 may further include a leveling assembly 130 for leveling the seed crystal rod 120 to make the seed crystal rod 120 vertical, which further enables the seed crystal support 110 to be always in a horizontal position during the crystal growth process, which is favorable to ensuring the quality of crystal growth. In some embodiments, the leveling assembly 130 may be connected to another end of the seed crystal rod 120.

In some embodiments, the leveling assembly 130 may include a supporting member 131, a connecting member 132, and an adjusting locking member.

The supporting member 131 may serve as a mounting base for mounting the connecting member 132 and the adjusting locking member. In some embodiments, the supporting member 131 may include an upper connecting block 1311, a lower connecting block 1312, and one or more connecting rods 1313.

The upper connecting block 1311 and the lower connecting block 1312 may be provided in parallel. For example, the upper connection block 1311 may be provided above the lower connection block 1312, and the connecting rod 1313 may be configured to connect the upper connection block 1311 and the lower connection block 1312. A mounting space may be formed between the upper connection block 1311 and the lower connection block 1312 for providing the connecting member 132 and the adjusting locking member.

In some embodiments, the lower connection block 1312 may be a flat plate-like structure. In some embodiments, the lower connection block 1312 may be a regular or irregular shape such as round shape, rectangular shape, square shape, or the like.

In some embodiments, the count of the one or more connecting rods 1313 may be at least two. In some embodiments, the connecting rods 1313 may be evenly distributed. For example, the connecting rods 1313 may be symmetrically distributed. As another example, the connecting rods 1313 may be symmetrically distributed with a symmetry line below an axis of the lower connection block 1312. In some embodiments, the count of the connecting rods 1313 may be at least three, and the connecting rods 1313 may be uniformly distributed circumferentially on an axis of the lower connection block 1312. In some embodiments, the upper connection block 1311 may be provided with a through hole through which the connecting rod 1313 may pass, and an end of each of the connecting rods 1313 near the upper connecting block 1311is provided with a limiting shaft shoulder. The limiting shaft shoulder may be configured to prevent the end of the connecting rod 1313 from passing through the through hole. An end of the connecting rod 1313 near the lower connecting block 1312 is provided with a threaded section. In some embodiments, the lower connection block 1312 may be threaded with the threaded section. In some embodiments, the lower connection block 1312 is provided with a through hole through which the threaded section may pass, and the threaded section is connected to at least one nut. In some embodiments, the at least one nut may be provided on the lower connecting block 1312.

The connecting member 132 is movably provided on the supporting member 131, and an end of the connecting member 132 is fixedly connected (e.g., glued, snap-fit, or threaded) to the another end of the seed crystal rod 120.

In some embodiments, the connecting member 132 may include a connecting sphere 1321 and an adjusting sphere 1322. In some embodiments, the connecting sphere 1321 and the adjusting sphere 1322 may be fixedly connected or integrally molded.

The connecting sphere 1321 may be connected to the supporting member 131. In some embodiments, the connecting sphere 1321 may movably abut against the supporting member 131, e.g., the connecting sphere 1321 and the supporting member 131 may rotate relative to each other. In some embodiments, the connecting sphere 1321 may movably abut against the lower connecting block 1312. In some embodiments, the seed crystal rod 120 is connected to the connecting sphere 1321. In some embodiments, the lower connection block 1312 is provided with a through hole and the connecting sphere 1321 cannot fully pass through the through hole provided on the lower connection block 1312, and the connecting sphere 1321 abuts against the through hole. In some embodiments, the shape of the through hole matches the shape of the portion of the connecting sphere 1321 abutting against the through hole. For example, when the connecting sphere 1321 is a sphere, the through hole may be circular and the radius of the through hole is less than or equal to the radius of the connecting sphere 1321. In some embodiments, the through hole may be located in the center of the lower connecting block 1312. In some embodiments, the seed crystal rod 120, the connecting sphere 1321, and the adjusting sphere 1322 may be coaxial.

In some embodiments, the adjusting sphere 1322 may include an upper hemisphere 13221 and a lower hemisphere 13222. In some embodiments, the upper hemisphere 13221 and the lower hemisphere 13222 may have the same or different diameters. For example, the upper hemisphere 13221 and the lower hemisphere 13222 may form a complete sphere, which may be understood to mean that the radii of the upper hemisphere 13221 and the lower hemisphere 13222 are equal and the centers of the upper hemisphere 13221 and the lower hemisphere 13222 are the same point. As another example, the diameter of the upper hemisphere 13221 may be smaller than the diameter of the lower hemisphere 13222, as shown in FIG. 2.

The adjusting locking member may be provided on the supporting member 131 for adjusting and locking a position of the connecting member 132 relative to the supporting member 131. The adjusting locking member contacts the adjusting sphere 1322. In some embodiments, the adjusting locking member may be utilized to apply a force to the adjusting sphere 1322 to level the seed crystal rod 120.

In some embodiments, the adjusting locking member may include an upper locking block 1331, an adjusting lever 1332, and a locking lever 1333.

The upper locking block 1331 may be disposed above the adjusting sphere 1322 for applying a vertically downward locking force to the connecting member 132. In some embodiments, the lower surface of the upper locking block 1331 rests against the adjusting sphere 1322. In some embodiments, the upper locking block 1331 may be slidably disposed within the upper connection block 1311. In some embodiments, a stepped hole is provided within the upper connection block 1311, with a relatively smaller hole of the stepped hole being provided near the adjusting sphere 1322. The upper locking block 1331 may be a stepped shaft adapted to the stepped hole. In some embodiments, the stepped hole may be coaxially provided with the lower connection block 1312. In some embodiments, the stepped hole may be threaded to the upper locking block 1331. When the upper locking block 1331 rotates one full turn, the upper locking block 1331 may move one pitch along the axial direction of the stepped hole, thereby enabling a fine-tuning feature. In some embodiments, a lower surface of the upper locking block 1331 may be a concave spherical surface, and a radius of the corresponding spherical surface of the lower surface of the upper locking block 1331 is greater than or equal to a radius of the adjusting sphere 1322. In some embodiments, the upper locking block 1331 and the adjusting sphere 1322 may be in point contact, line contact, or surface contact.

The adjusting lever 1332 and the locking lever 1333 may be provided opposite each other on two sides of the adjusting sphere 1322. The adjusting lever 1332 is provided on a side of the adjusting sphere 1322, and an end of the adjusting lever 1332 resists a surface of the adjusting sphere 1322. In some embodiments, the adjusting lever 1332 may be moved along a length direction of the adjusting lever 1332 to exert a force on the adjusting sphere 1322. In some embodiments, the adjusting lever 1332 may abut against the adjusting sphere 1322 in a direction of the non-surface tangent of the adjusting sphere 1322. In some embodiments, the adjusting lever 1332 may abut against the adjusting sphere 1322 along a radial direction of a cross-sectional circle of the adjusting sphere 1322. In some embodiments, the cross-sectional circle may be a circle formed by intersecting the adjusting sphere 1322 with a plane not passing the center of the adjusting sphere 1322. In some embodiments, the lengthwise direction of the adjusting lever 1332 may be spatially perpendicular to an axis of the lower connecting block 1312. In some embodiments, the lengthwise direction of the adjusting lever 1332 may intersect perpendicularly with the axis of the lower connection block 1312.

The locking lever 1333 is provided on another side of the adjusting sphere 1322, with an end of the locking lever 1333 abutting against a surface of the adjusting sphere 1322. In some embodiments, the locking lever 1333 may be moved along the length direction of the locking lever 1333 to exert a force on the adjusting sphere 1322. In some embodiments, the locking lever 1333 may abut against the adjusting sphere 1322 in the direction of the non-surface tangent of the adjusting sphere 1322. In some embodiments, the locking lever 1333 may abut against adjusting sphere 1322 along the radial direction of the cross-sectional circle of the adjusting sphere 1322. In some embodiments, the cross-sectional circle may be a circle formed by intersecting the adjusting sphere 1322 with the plane not passing the center of the adjusting sphere 1322. In some embodiments, the lengthwise direction of the locking lever 1333 may be spatially perpendicular to the axis of the lower connecting block 1312. In some embodiments, the lengthwise direction of the locking lever 1333 may intersect perpendicularly with the axis of the lower connection block 1312.

In some embodiments, the adjusting lever 1332 and the locking lever 1333 may be located on different sides of the adjusting sphere 1322, respectively. For example, the adjusting lever 1332 and the locking lever 1333 may be disposed on the left and right sides of the adjusting sphere 1322, respectively, as shown in FIG. 2.

When adjusting, the upper locking block 1331 contacts the adjusting sphere 1322 (e.g., the upper hemisphere 13221), controls the expansion and contraction of the adjusting lever 1332, and utilizes the adjusting lever 1332 to drive the adjusting sphere 1322 (e.g., the upper hemisphere 13221 and the lower hemisphere 13222). The adjusting sphere 1322 drives the connecting sphere 1321 and the seed crystal rod 120 to move. When the seed crystal rod 120 is moved into place (e.g., the seed crystal rod 120 is moved to a vertical state, or the seed crystal support 110 is held level in a crucible), the adjusting lever 1332 is controlled to be held stationary. Then the locking rod 1333 is controlled to be extended so that the locking rod 1333 abuts against the adjusting sphere 1322. In a natural state, or without disrupting the position of the locking lever 1333 and the adjusting lever 1332, the adjusting sphere 1322 may remain stationary. In some embodiments, after the locking lever 1333 has been locked, the upper locking block 1331 may then be controlled to move downwardly, applying pressure to the adjusting sphere 1322, thereby further locking the adjusting sphere 1322.

In some embodiments, the adjusting lever 1332 and the locking lever 1333 may be in point contact with the adjusting sphere 1322. In some embodiments, at least one of the adjusting lever 1332 or the locking lever 1333 may be in line contact or surface contact with the adjusting sphere 1322. For example, the adjusting lever 1332 is in point contact with the upper hemisphere 13221. The locking lever 1333 is in line or surface contact with the lower hemisphere 13222. Compared with the point contact, the contact area of the line contact or the surface contact is larger, and the friction at the contact position is larger so that the phenomenon of slippage does not occur, which is conducive to improve the precision of adjustment.

In some embodiments, an end of the adjusting lever 1332 near the adjusting sphere 1322 is provided with an adjusting ball 13321, and the adjusting ball 13321 contacts the adjusting sphere 1322. When the adjusting lever 1332 is pushed, the force is transferred to the adjusting sphere 1322 through the adjusting ball 13321, and the adjusting ball 13321 is in contact with the adjusting sphere 1322 through a spherical surface, which may avoid the outer surface of the adjusting sphere 1322 from being scratched. In some embodiments, one end of the locking lever 1333 near the adjusting sphere 1322 is provided with a locking ball 13331, and the locking ball 13331 is in contact with the adjusting sphere 1322. In some embodiments, the locking ball 13331 and the adjusting ball 13321 may be of the same or different structure and function. In some embodiments, the locking ball 13331 and the adjusting ball 13321 may be made of stainless steel. The material of the adjustment sphere 1322 may also be stainless steel. A friction coefficient between the locking ball 13331 and the adjusting sphere 1322 (e.g., the lower hemisphere 13222), and a friction coefficient between the adjusting ball 13321 and the adjusting sphere 1322 (e.g., the upper hemisphere 13221) may be within a range of 0.1-0.2.

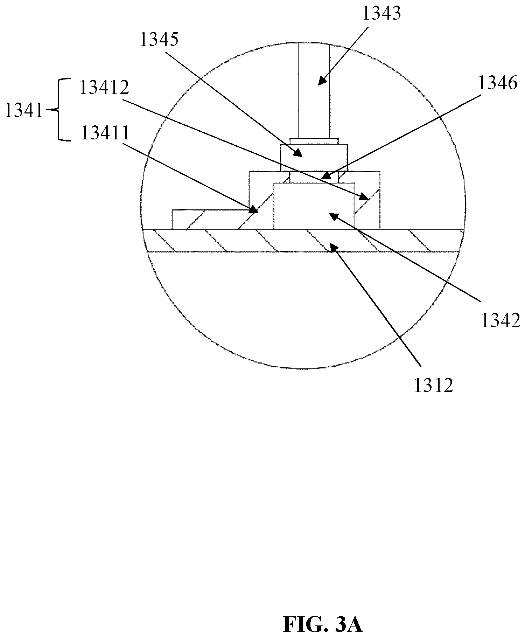

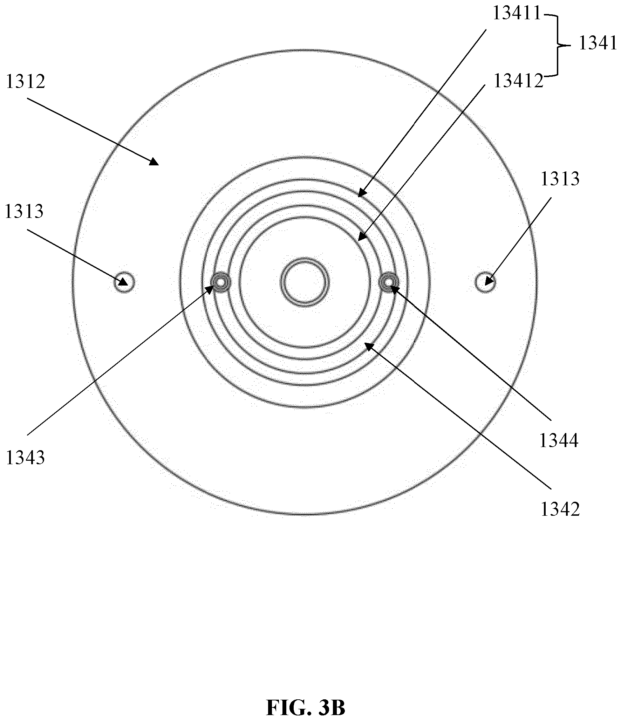

FIG. 3A is a localized enlarged view of region A in FIG.2. FIG. 3B is a top view of a lower connecting block.

As shown in FIG. 2 and FIG. 3A, the adjusting locking member further includes an annular guide rail 1341, an annular slider 1342, an adjusting lever pillar 1343 and a locking lever pillar 1344.

The annular guide rail 1341 may be provided on the lower connecting block 1312, and the annular slider 1342 may be slidably provided within the annular guide rail 1341. In some embodiments, the annular guide rail 1341, the annular slider 1342, and the lower connection block 1312 may be coaxially provided. The annular guide rail 1341 may be configured to limit the rotation direction of the annular slider 1342.

In some embodiments, as shown in FIG. 3B, the annular guide rail 1341 may include an outer ring 13411 and an inner ring 13412, and the annular slider 1342 is disposed in a groove formed between the outer ring 13411 and the inner ring 13412.

The adjusting lever pillar 1343 may be configured to install the adjusting lever 1332. In some embodiments, the adjusting lever pillar 1343 and the locking lever pillar 1344 may be disposed on the annular slider 1342. When the annular slider 1342 is rotated, the adjusting lever pillar 1343 and the locking lever pillar 1344 may be driven to simultaneously rotate. In some embodiments, a groove may be formed between the outer ring 13411 and the inner ring 13412, and the groove may be configured to accommodate the annular slider 1342. A gap above the groove may also be formed between the outer ring 13411 and the inner ring 13412, the width of the gap may be smaller than the width of the groove, and the gap may be configured to accommodate the adjusting lever pillar 1343 and the locking lever pillar 1344 passing through to prevent the adjusting lever pillar 1343 from interfering with the annular guide rail 1341, or the locking lever pillar 1344 from interfering with the annular guide rail 1341.

In some embodiments, the adjusting lever pillar 1343 and the locking lever pillar 1344 may be symmetrically distributed.

In some embodiments, the adjusting lever pillar 1343 may be provided with a threaded section 1346 connected to a locking nut 1345. When it is necessary for the annular slider 1342 to remain fixed, the locking nut 1345 may be tightened so that the locking nut 1345 is pressed against the annular guide rail 1341 to keep the annular slider 1342 fixed. In some embodiments, the threaded section 1346 may also be provided on the locking lever pillar 1344. The structure and function of the threaded section 1346 on the locking lever pillar 1344 and the threaded section 1346 on the adjusting lever pillar 1343 may be the same, and may not be described herein.

In some embodiments, the adjusting lever 1332 may be threadedly connected to the adjusting lever pillar 1343. In some embodiments, the adjusting lever 1332 is provided with an external thread, and the adjusting lever pillar 1343 is provided with a threaded hole adapted to the external thread. In some embodiments, the axis of the threaded hole may intersect perpendicularly with the axis of the lower connecting block 1312. The adjusting lever 1332 may be moved by rotating the adjusting lever 1332 along a lengthwise direction of the adjusting lever 1332, thereby pushing the adjusting sphere 1322 to move. By making the adjusting lever 1332 threaded with the adjusting lever pillar 1343, when the adjusting lever 1332 is rotated by one turn, the adjusting lever 1332 may move by one pitch, which may realize the function of fine adjustment. In some embodiments, the locking lever pillar 1344 and the locking lever 1333 may be in a thread connection.

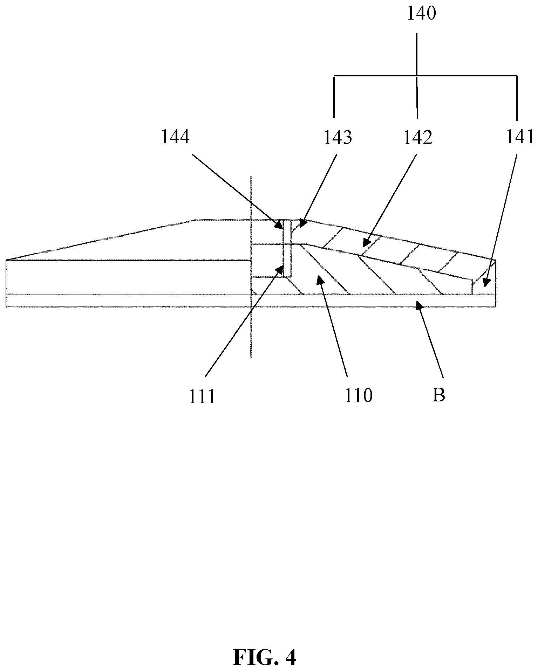

FIG. 4 is a schematic diagram illustrating an exemplary seed crystal support and a protection assembly according to some other embodiments of the present disclosure.

As shown in FIG. 4, the connecting device 100 may also include a protection assembly 140 for protecting the seed crystal support 110. The protection assembly 140 may be connected to the seed crystal support 110.

The protection assembly 140 may cover an edge and an upper surface of the seed crystal support 110, which may prevent creeping, i.e., preventing gas-phase components within the crucible from crystallizing on the edge and the upper surface of the seed crystal support 110, and preventing the crystal from being difficult to remove during subsequent crystal removal. In some embodiments, the protection assembly 140 may be adhered to an outer periphery and an upper surface of the seed crystal support 110, preventing the gas-phase components from entering into a gap between the protection assembly 140 and the seed crystal support 110, or preventing the gas-phase components and the seed crystal support 110 from reacting, resulting in an inability to remove the crystal.

In some embodiments, the material of the protection assembly 140 may include, but is not limited to, boron nitride.

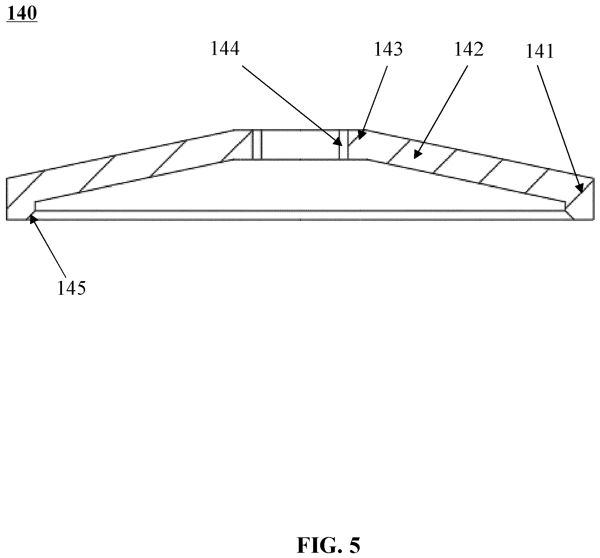

FIG. 5 is a schematic diagram illustrating an exemplary protection assembly according to some embodiments of the present disclosure.

As shown in FIG. 4 and FIG. 5, the protection assembly 140 may include an annular portion 141, a connecting portion 142, and a fixing portion 143. The connecting portion 142 may be connected between the annular portion 141 and the fixing portion 143. In some embodiments, the annular portion 141, the connecting portion 142, and the fixing portion 143 may be integrally molded or fixedly connected.

The annular portion 141 may cover a side surface of the seed crystal support 110. In some embodiments, the annular portion 141 may be configured to prevent the gas-phase components in the crucible from contact with the side surface of the seed crystal support 110 to protect the seed crystal support 110. In some embodiments, the annular portion 141 may be fully affixed to the side surface of the seed crystal support 110.

In some embodiments, as shown in FIG. 5, a chamfer 145 may be provided on the annular portion 141. The chamfer 145 may be provided between an inner side surface and a lower surface of the annular portion 141. An annular holding space may be formed between the chamfer 145 and the seed crystal support 110, and the annular holding space may be used to hold an adhesive for bonding the seed crystal support 110 and a seed crystal B. In some embodiments, the diameter of the seed crystal B may be larger than the diameter of the seed crystal support 110, and a portion of the seed crystal B that extends beyond the seed crystal support 110 may be in contact with the annular portion 141, as shown in FIG. 4.

The connecting portion 142 may be connected to the annular portion 141. The connecting portion 142 may also cover the upper surface of the seed crystal support 110, and the connecting portion 142 may prevent the gas-phase components in the crucible from contacting the upper surface of the seed crystal support 110, thereby protecting the upper surface of the seed crystal support 110. In some embodiments, the connecting portion 142 may be fully affixed to the upper surface of the seed crystal support 110.

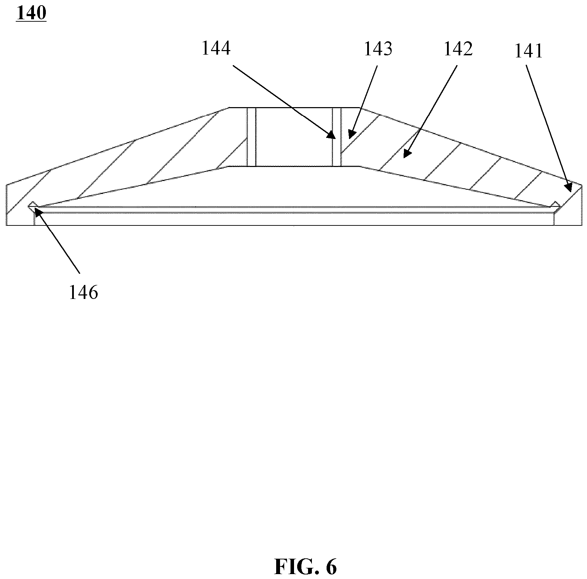

FIG. 6 is a schematic diagram illustrating an exemplary protection assembly according to some other embodiments of the present disclosure.

In some embodiments, the thickness of the connecting portion 142 near the center of the connecting portion 142 or near the fixing portion 143 may be greater than a thickness of an edge portion of the connecting portion 142 or near the annular portion 141, as shown in FIG. 6. Since the temperature of the center portion of the seed crystal support 110 is generally lower than the temperature near an edge portion of the seed crystal support 110, such a thickness setting may make the center of the connecting portion 142 better insulated so that the seed crystal support 110 have a uniform temperature distribution. In some embodiments, the material of the annular portion 141 and the connecting portion 142 is boron nitride.

The fixing portion 143 is provided in the connecting portion 142, and the fixing portion 143 may be connected to the seed crystal rod 120, which enables the protection assembly 140 to remain relatively stable to the seed crystal support 110. In some embodiments, the fixing portion 143 is provided in the middle position of the connecting portion 142.

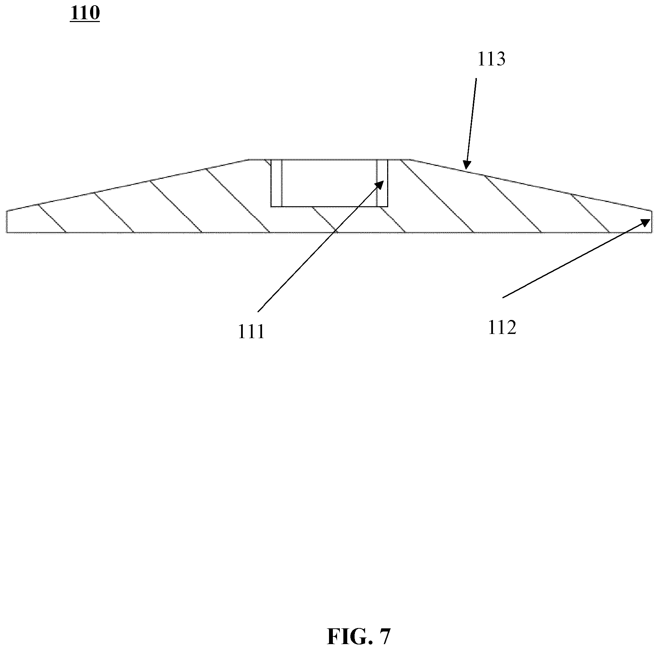

FIG. 7 is a schematic diagram illustrating an exemplary seed crystal support according to some other embodiments of the present disclosure.

In some embodiments, as shown in FIG. 7, the seed crystal support 110 may include an attached cylindrical portion 112 and a truncated cone portion 113 connected with the cylindrical portion. In some embodiments, the cylindrical portion 112 and the truncated cone portion 113 may be integrally molded. In some embodiments, the cylindrical portion 112 may be mechanically connected (e.g., clamped, glued, fastened, threaded, or welded) with the truncated cone portion 113. In some embodiments, the annular portion 141 may be affixed to an outer periphery or a portion of an outer periphery of the cylindrical portion 112, as shown in FIG. 4. In some embodiments, the connecting portion 142 may be affixed to an upper surface of the seed crystal support 110, or the connecting portion 142 may be affixed to an upper surface and a portion of the outer periphery of the seed crystal support 110.

In some embodiments, as shown in FIG. 6, an avoidance groove 146 may be provided between an inner side surface of the connecting portion 142 and an inner side surface of the annular portion 141, and the avoidance groove 146 may be provided to match with the shape corner at the joint of the cylindrical portion 112 and the truncated cone portion 113 to avoid interference during installation. In some embodiments, the avoidance groove 146 may be rectangular in cross-section. In some embodiments, the avoidance groove 146 may be a concave rounded corner.

In some embodiments, one end of the seed crystal rod 120 includes an external thread (not shown in the figures), as shown in FIGs. 5 and 6, and the fixing portion 143 includes a first internal thread 144 that matches the external thread, and the fixing portion 143 may be threaded with the seed crystal rod 120.

In some embodiments, as shown in FIG. 7, the seed crystal support 110 is provided with a second internal thread 111 that matches the male thread, and the internal thread on the seed crystal rod 120 may be threaded with both the seed crystal support 110 and the fixing portion 143 as to connecting the protection assembly 140, the seed crystal support 110, and the seed crystal rod 120.

In some embodiments, the protection assembly 140 may also include a key (not shown in the figures). In some embodiments, the seed crystal support 110 is provided with a keyway that fits into the key on the fixing portion 143. The keyway may be provided between the seed crystal support 110 and the fixing portion 143. The key may limit a relative rotation of the seed crystal support 110 and the protection assembly 140 (e.g., the connecting portion 142), improving the stability of the protection assembly 140.

As shown in FIG. 8, the connecting device 100 may include at least one seed crystal rod 120 and a seed crystal support 110.

An end of the at least one seed crystal rod 120 may be connected to the seed crystal support 110. In some embodiments, another end of the at least one seed crystal rod 120 may be connected to a transmission assembly (not shown in the figures). The transmission assembly may drive the at least one seed crystal rod 120 to rotate to further rotate the seed crystal support 110 (and the seed crystal adhered thereto) to rotate.

In some embodiments, the seed crystal support 110 may be connected with the at least one seed crystal rod 120 in a variety of ways.

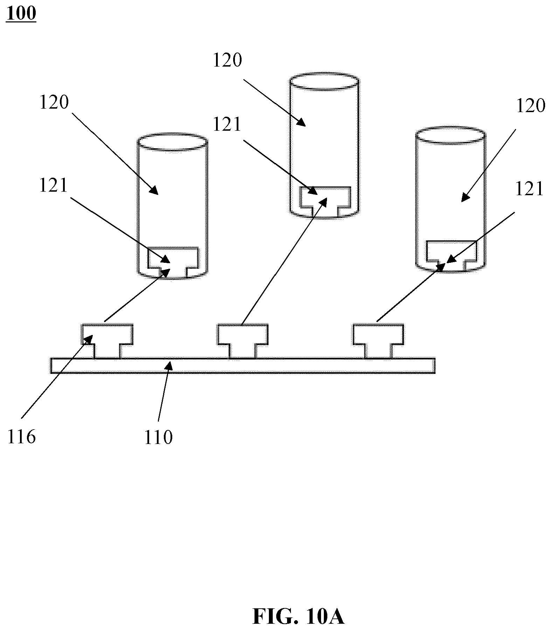

In some embodiments, the seed crystal support 110 may be in a slot connection with the at least one seed crystal rod 120. In some embodiments, the slot connection may include a connecting block and a connecting groove adapted to each other to tighten the connection between the seed crystal support 110 and the at least one seed crystal rod 120. Descriptions regarding the slot connection may be found elsewhere in the present disclosure (e.g., FIGs. 10A-FIG. 12 and related descriptions thereof) and may not be repeated here.

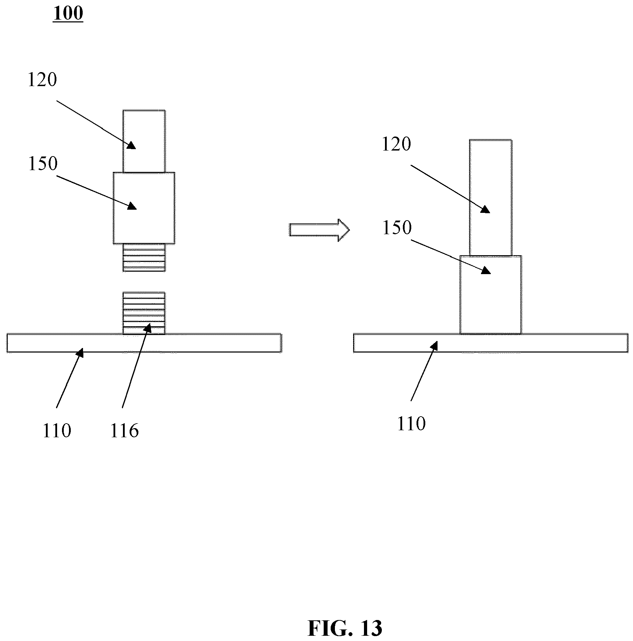

In some embodiments, the seed crystal support 110 may be in thread connection with the at least one seed crystal rod 120. Descriptions regarding the connection may be found elsewhere in the present disclosure (e.g., FIG. 13 and related descriptions thereof) and may not be repeated here.

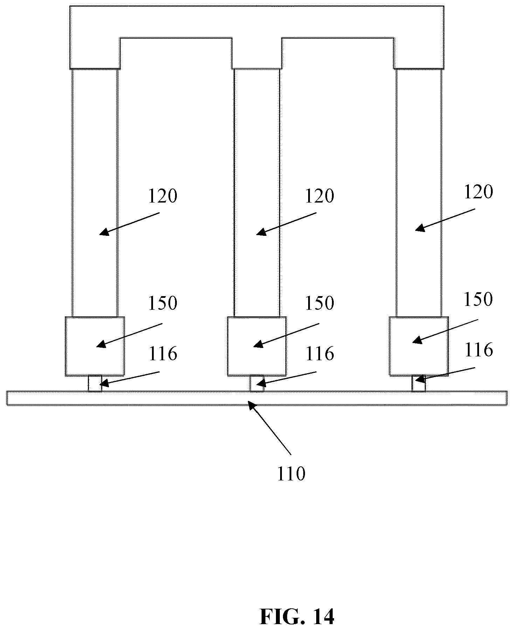

In some embodiments, the seed crystal support 110 may be connected to at least two seed crystal rods 120. Descriptions regarding the connection between the seed crystal support 110 and the at least two seed crystal rods 120 may be found elsewhere in the present disclosure (e.g., FIG. 14 and the related description thereof) and may not be repeated here.

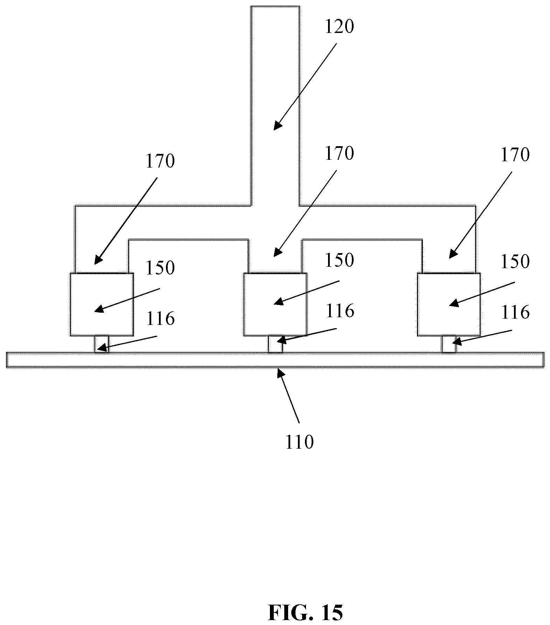

In some embodiments, the seed crystal support 110 may be connected to the seed crystal rod 120 via at least two connection pins. Descriptions regarding the connection between the seed crystal support 110 and the seed crystal rod 120 via the at least two connecting pins may be found elsewhere in the present disclosure (e.g., FIG. 15 and the related description thereof) and may not be repeated here.

In some embodiments, the count of connection points connecting the seed crystal support 110 and the at least one seed crystal rod 120 is greater than or equal to 2, and the connection points do not coincide with the rotation center of the seed crystal support 110.

In some embodiments, a connection point between the seed crystal support 110 and the at least one seed crystal rod 120 refers to a location at which the at least one seed crystal rod 120 is in contact with and in a direct connection with the seed crystal support 110. In some embodiments, a connection point between the seed crystal support 110 and the at least one seed crystal rod 120 refers to a location where a connection medium contacts the seed crystal support 110 when the at least one seed crystal rod 120 is indirectly connected to the seed crystal support 110 via the connection medium (e.g., a connection pin).

In some embodiments, the rotation center of the seed crystal support 110 refers to a fixed point at which the seed crystal support 110 rotates. In some embodiments, the rotation center of the seed crystal support 110 may be located at its gravity center, center, or other location.

By setting the connection points do not coincide with the rotation center of the seed crystal support 110, when the transmission assembly drives the at least one seed crystal rod 120 to rotate and thereby drives the seed crystal support 110 to rotate, the rotation of the seed crystal support 110 does not result in a loosening of the connection between the at least one seed crystal rod 120 and the seed crystal support 110. In addition, setting the count of connection points to be greater than or equal to 2 ensures a stable and solid connection of the seed crystal, and thus ensures the normal growth of the crystals.

In some embodiments, the connection points may be evenly distributed on the seed crystal support 110.

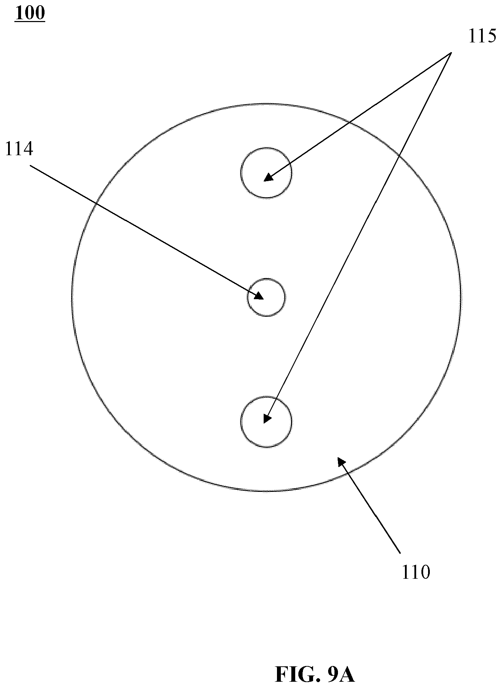

In some embodiments, the connection points may be uniformly distributed along a circumferential direction of the seed crystal support 110 to ensure a stable connection between the at least one seed crystal rod 120 and the seed crystal support 110, to keep the seed crystal support 110 in a smooth state, and thus ensure the normal growth of the crystals. Descriptions regarding the distribution of the connection points may be found elsewhere in the present disclosure (e.g., FIGs. 9A-9C and related descriptions thereof) and may not be repeated here.

In some embodiments, the at least one seed crystal rod 120 may be integrally molded.

In some embodiments, the at least one seed crystal rod 120 may include a plurality of connecting segments, and the plurality of connecting segments are connected to form the seed crystal rod 120. By connecting the plurality of connecting segments, an overall length of the seed crystal rod 120 may be more conveniently and flexibly adjusted, thereby applying to various application scenarios. In some embodiments, how the plurality of connecting segments are connected to form the seed crystal rods 120 and how the seed crystal support 110 is connected to the at least one seed crystal rod 120 may be the same or different.

In some embodiments, a connection point between two connecting segments refer to a location where two neighboring connecting segments are connected to contact each other. In some embodiments, the connection points of the plurality of connecting segments may not coincide with the rotation center of the seed crystal support 110. When the transmission assembly drives the at least one seed crystal rod 120 to rotate and thereby drives the seed crystal support 110 to rotate, because the connection points of the plurality of connecting segments do not coincide with the rotation center of the seed crystal support 110, the rotation of the seed crystal support 110 does not cause the connection between the plurality of connecting segments to loosen. Accordingly, a solid connection of the seed crystal may be ensured, and thus the normal growth of the crystals may be ensured.

It should be noted that the foregoing description of the connecting device 100 is for the purpose of exemplification and illustration only and does not limit the scope of application of the present disclosure. For a person skilled in the art, various corrections and changes may be made to the connecting device 100 under the guidance of the present disclosure. However, these corrections and changes remain within the scope of the present disclosure. For example, when the seed crystal support 110 is in a slot connection with the at least one seed crystal rod 120, due to the relative robustness of the slot connection, it may also be possible to eliminate the need to restrict the connection points from not coinciding with to the rotation center of the seed crystal support 110 and the count of connection points is greater than or equal to 2. That is to say, when the seed crystal support 110 is in the slot connection with the at least one seed crystal rod 120, the connection points may be only one and located in the rotation center of the seed crystal support 110.

FIGs. 9A-9C are schematic diagrams illustrating a distribution of exemplary connection points according to some embodiments of the present disclosure. For ease of description, the shape of the seed crystal support 110 in FIGs. 9A-9C is exemplarily depicted as a circle, and the shape of the seed crystal support 110 may be other shapes, such as a rectangle, a square, a triangle, etc., which is not limited in the present disclosure.

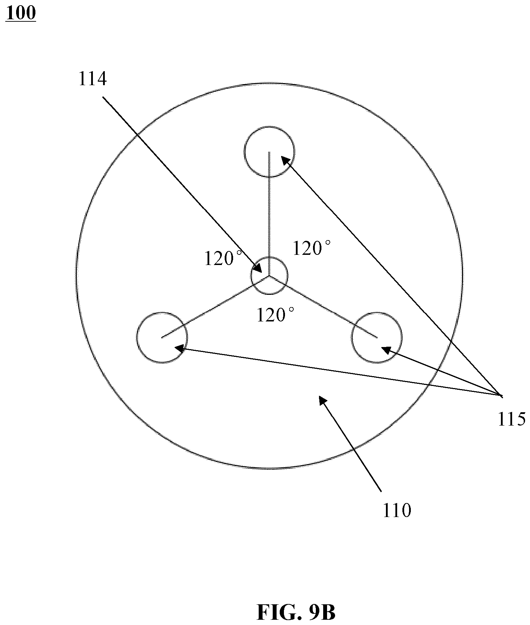

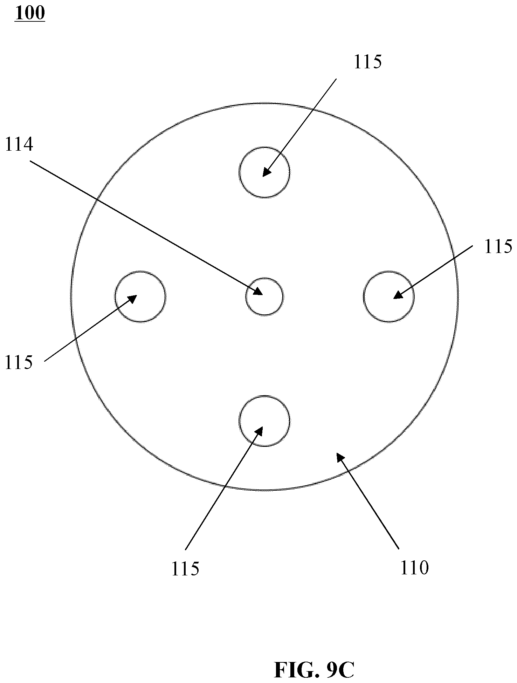

As shown in FIGs. 9A-9C, the seed crystal support 110 is circular and a rotation center 114 may be located at the center (or center) of the circle. As shown in FIG. 9A, the count of connection points 115 is 2, and are symmetrically distributed on two sides of the rotation center 114 of the seed crystal support 110. As shown in FIG. 9B, the count of connection points 115 is 3, and are evenly distributed around the rotation center 114 of the seed crystal support 110 (i.e., included angles between lines connecting the three connection points 115 and the rotation center 114 of the seed crystal support 110 are all 120°). As shown in FIG. 9C, the count of connection points 115 is four and are uniformly distributed around the rotation center 114 of the seed crystal support 110 (i.e., included angles between the lines connecting the four connection points 115 and the rotation center 114 of the seed crystal support 110 are all 90°).

By setting the distribution of the connection points to be uniformly distributed along the circumferential direction of the seed crystal support 110, the connection between the seed crystal rod 120 and the seed crystal support 110 may be ensured to be stable, so that the seed crystal support 110 may be in a smooth state during the rotation process, and thus ensure the normal growth of the crystal.

It should be noted that the foregoing descriptions regarding the distribution of the connection points are for the purpose of exemplification and illustration only and do not limit the scope of the present disclosure. For a person skilled in the art, various corrections and changes may be made to the distribution of the connection points under the guidance of the present disclosure. However, these corrections and changes remain within the scope of the present disclosure.

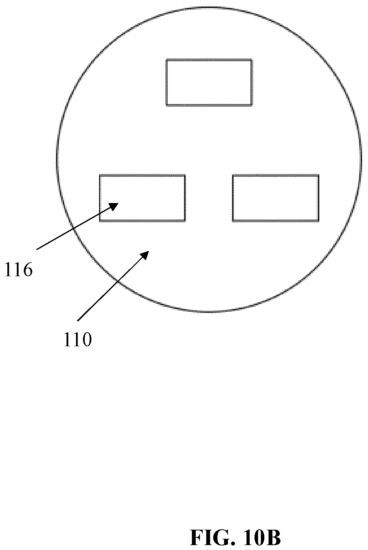

FIGs. 10A-10B are schematic diagrams illustrating a slot connection between a seed crystal support and at least one seed crystal rod according to some embodiments of the present disclosure. As shown in FIG. 10A, the seed crystal rod 120 is provided with a connecting groove 121, and the seed crystal support 110 is provided with a connecting block 116, and the connecting groove 121 is adapted with the connection block 116, so as to ensure that the seed crystal rod 120 is fixedly connected with the seed crystal support 110. In some embodiments, as shown in FIG. 10B, the connection block 116 may be evenly spaced along the circumference of the seed crystal support 110 (e.g., included angles each of which is between a connection line connecting one of three connection blocks 116 and the rotation center of the seed crystal support 110 are all 120°).

In some embodiments, as shown in FIGs. 10A and 10B, the connection block 116 may be a T-shaped block. Accordingly, the connecting groove 121 may be a T-shaped groove that adapts to the T-shaped block. In some embodiments, when the seed crystal support 110 is connected to at least two seed crystal rods 120 (e.g., three seed crystal rods 120 shown in FIG. 10A), each connecting groove 121 may correspond to one connecting block 116, and then the connecting block 116 (e.g., the three connecting blocks 116 shown in FIG. 10A) is inserted into the connecting groove 121 from sides of the at least two seed crystal rods 120 (shown by arrows in FIG. 10A).

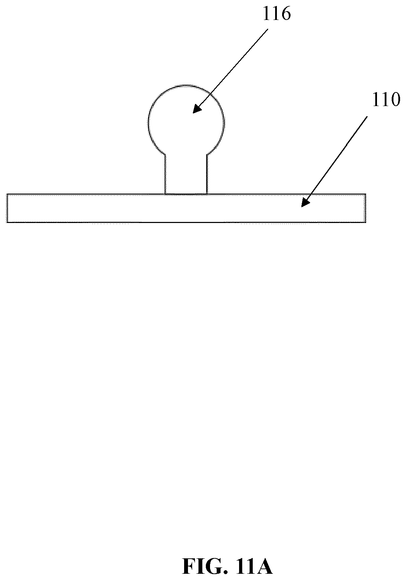

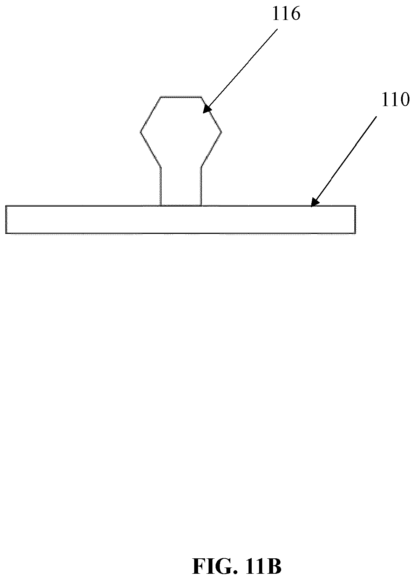

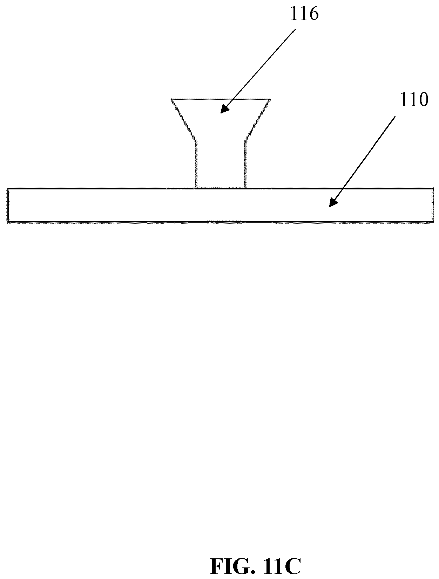

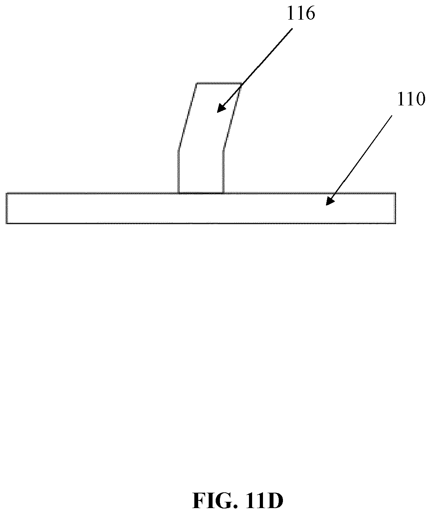

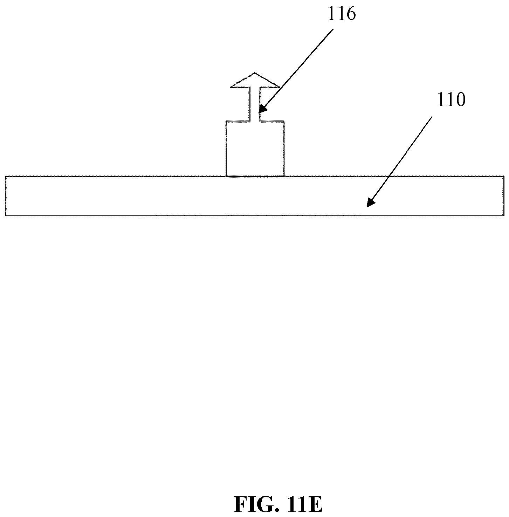

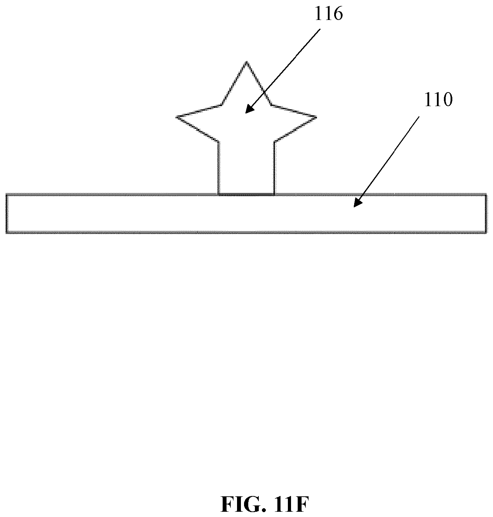

In some embodiments, the connection block 116 may also be any other shape. FIGs. 11A-11F are schematic diagrams illustrating an exemplary connecting block according to some embodiments of the present disclosure. In some embodiments, as shown in FIG. 11A, one end of the connecting block 116 that snaps into the seed crystal rod 120 is a round sphere, an ellipsoid sphere, or a sphere-like body. In some embodiments, as shown in FIG. 11B, the end of the connection block 116 that snaps into the seed crystal rod 120 is a polyhedron. In some embodiments, as shown in FIGs. 11C and 11D, one end of the connecting block 116 that snaps into the seed crystal rod 120 is a prismoid (e.g., a quadrangular prismoid). In some embodiments, as shown in FIG. 11E, one end of the connection block 116 that snaps into the seed crystal rod 120 is a prism (e.g., triangular prism, quadrangular prism). In some embodiments, as shown in FIG. 11F, one end of the connection block 116 that snaps into the seed crystal rod 120 is a regular or irregular body with a partially star-shaped shape.

In some embodiments, one end of the connection block 116 connected to the seed crystal support 110 may be of any shape (e.g., cylindrical), and the present disclosure does not limit the end of the connection block 116 connected to the seed crystal support 110, other than that the connection block 116 is firmly connected to the seed crystal support 110.

For ease of description, FIGs. 11A-11F show schematic diagrams illustrating the seed crystal support 110 provided with the connection block. In conjunction with the foregoing, the count of the connection block 116 is greater than or equal to 2. In some embodiments, shapes of a plurality of connection blocks 116 on the seed crystal support 110 may be the same or different.

It should be noted that the foregoing description of the connection block is for the purpose of exemplification and illustration only and does not limit the scope of the present disclosure. For a person skilled in the art, various corrections and alterations can be made to the connecting block under the guidance of the present disclosure. However, these corrections and changes remain within the scope of the present disclosure.

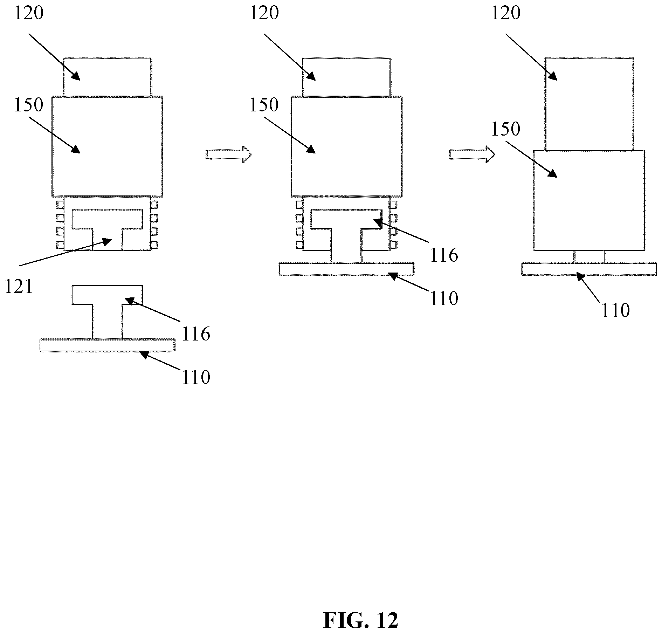

In some embodiments, the connecting device 100 may also include a connecting ring (e.g., the connecting ring 150 as shown in FIG. 12). In some embodiments, the connecting ring may be threaded with the seed crystal rod 120 provided with the connecting groove 121 to fix the connection block 116 inserted within the connecting groove 121, further connecting the seed crystal rod 120 fixedly to the seed crystal support 110. For example, the connecting ring may be provided with an internal thread, and the outer periphery of the seed crystal rod 120 may be provided with an external thread that matches the internal thread.

FIG. 12 is a schematic diagram illustrating a connection process of a seed crystal support being connected with a seed crystal rod via a slot connection according to some embodiments of the present disclosure. As shown in FIG. 12, when the seed crystal support 110 is connected to the seed crystal rod 120, the connecting groove 121 may be connected opposite the connecting block 116, and then the connecting block 116 may be inserted into the connecting groove 121 from a side of the seed crystal rod 120. Then, by rotating the connecting ring 150 to be screwed into an end of the seed crystal rod 120 that is provided with an external thread on the outer periphery of the seed crystal rod 120 to fix the connecting block 116 inside the seed crystal rod 120, realizing a firm connection between the seed crystal support 110 and the seed crystal rod 120.

FIG. 13 is a schematic diagram illustrating a connection process of a seed crystal support being threadedly connected to a seed crystal rod according to some embodiments of the present disclosure. As shown in FIG. 13, the seed crystal support 110 may be provided with a connecting block 116. An outer periphery of the connection block 116 may be provided with an external thread, and an outer periphery of one end of the seed crystal rod 120 connected with the seed crystal support 110 may be provided with an external thread. The connecting ring 150 may be provided with an internal thread. As shown in FIG. 13, when the seed crystal support 110 is connected to the seed crystal rod 120, the end of the seed crystal rod 120 provided with the external thread may be connected to the connecting block 116, and then, by rotating the connecting ring 150, which is screwed into the end of the seed crystal rod 120 provided with the external thread at the periphery of the seed crystal rod 120, to make the seed crystal rod 120 be connected with the connecting block 116, further realizing a firm connection between the seed crystal support 110 and the seed crystal rod 120.

In some embodiments, the connecting device 100 may not include a connecting ring. In some embodiments, the connecting block 116 may be provided with the external (or internal) thread, and the end of the seed crystal rod 120 connecting the seed crystal support 110 (or connecting block 116) may be provided with the internal (or external) thread. The external (or internal) thread on the connecting block 116 and the internal (or external) thread on the seed crystal rod 120 may be mated. When connecting, the seed crystal rod 120 is screwed into the interior of the connection block 116, or the connection block 116 is screwed into the interior of the seed crystal rod 120, allowing for a firm connection between the seed crystal support 110 and the seed crystal rod 120.

FIG. 14 is a schematic diagram illustrating a connection between a seed crystal support and at least two seed crystal rods according to some embodiments of the present disclosure.

As shown in FIG. 14, the connecting device 100 includes three seed crystal rods 120, a seed crystal support 110, and a connecting ring 150.

The seed crystal support 110 is connected to the three seed crystal rods 120, and a count of connection points is 3. The connection points do not coincide with the rotation center of the seed crystal support 110, and the distribution of the connection points may be as shown in FIG. 9B.

In conjunction with FIG. 12, the seed crystal support 110 is in a slot connection with the seed crystal rod 120. The seed crystal support 110 is provided with a connecting block 116, and an end of the seed crystal rod 120 connecting the seed crystal support 110 is provided with a connecting groove (not shown in FIG. 14). The seed crystal rod 120 is in a threaded connection with the connecting ring 150.

The connection device 100 may also include a drive connecting member 160 for connecting the seed crystal rod 120 to the transmission assembly (not shown in FIG. 14). In some embodiments, the drive connecting member 160 may be in the slot connection or threaded connection with the seed crystal rod 120. The connection between the drive connecting member 160 and the seed crystal rod 120 and the connection between the seed crystal rod 120 and the seed crystal support 110 may be the same or different.

FIG. 15 is a schematic diagram illustrating a connection between a seed crystal support and a seed crystal rod via at least two connecting pins according to some embodiments of the present disclosure.

As shown in FIG. 15, the connecting device 100 includes a seed crystal rod 120, a seed crystal support 110, and three connecting pins 170. The seed crystal rod 120 may be indirectly connected to the seed crystal support 110 via the three connection pins 170. The seed crystal rod 120 and three connection pins 170 may be integrally molded or may be connected by other means (e.g., slot connection and threaded connection).

A connection point connecting the seed crystal support 110 with one seed crystal rod 120 may be represented as connection points connecting the seed crystal support 110 with three connection pins 170. The count of connection points is 3, the connection points do not coincide with the rotation center of the seed crystal support 110, and the distribution of the connection points may be as shown in FIG. 9B.

In conjunction with FIG. 12, the seed crystal support 110 is in a slot connection with the connecting pin 170. The seed crystal support 110 is provided with a connecting block 116, and the end of the connecting pin 170 connecting the seed crystal support 110 may be provided with a connecting groove (not shown in FIG. 15). The connecting pin 170 is provided with an external thread externally, and the connecting ring 150 is provided with an internal thread internally, and the connecting pin 170 and the connecting ring 150 may be connected by a thread.

It should be noted that the foregoing description of the connecting device is for the purpose of exemplification and illustration only, and does not limit the scope of the present disclosure. For a person skilled in the art, various corrections and changes may be made to the connecting device under the guidance of the present disclosure. However, these corrections and changes remain within the scope of the present disclosure.

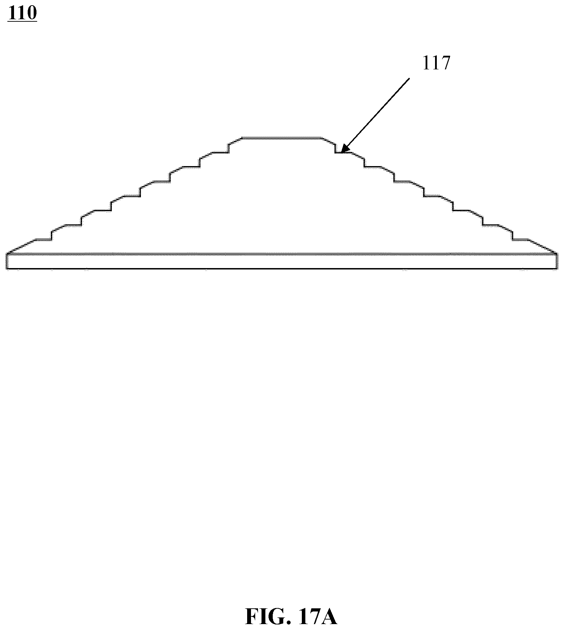

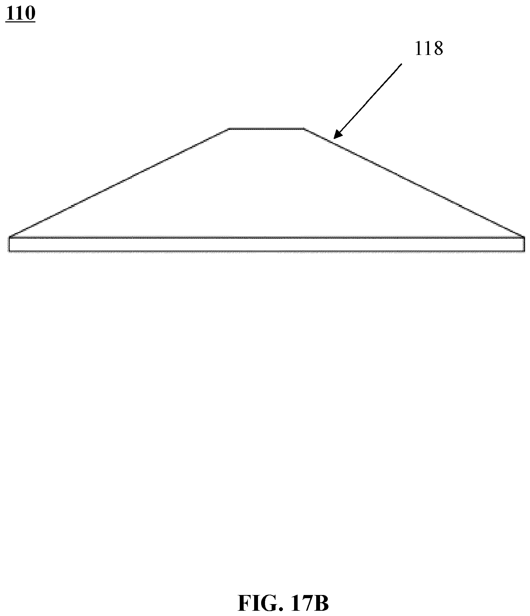

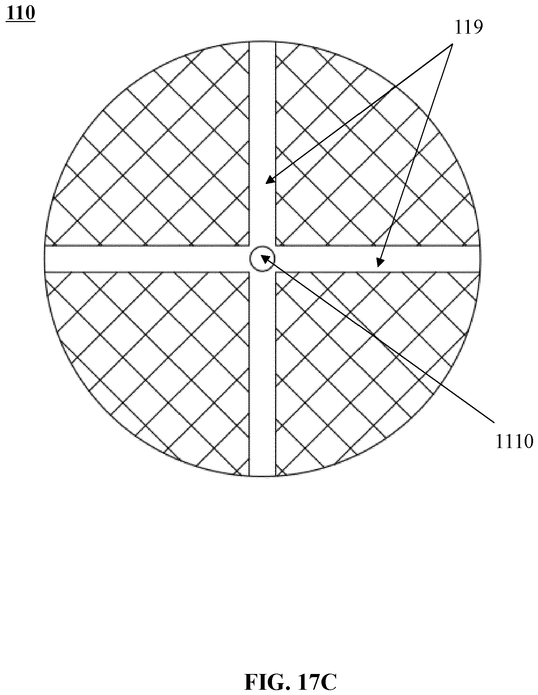

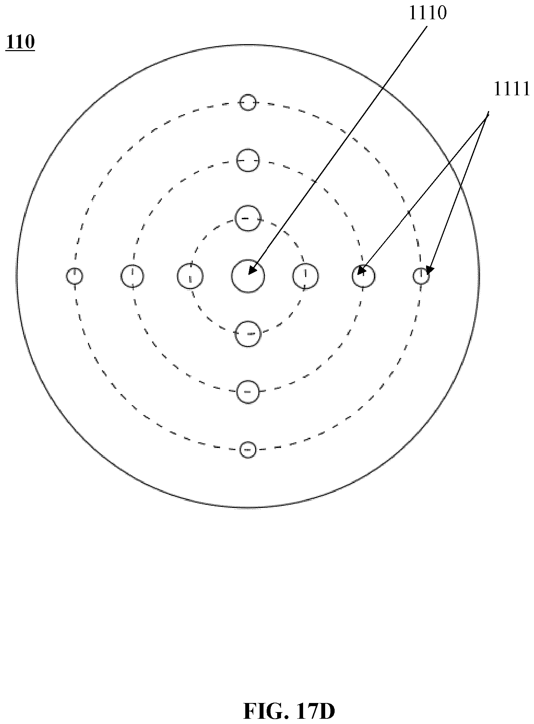

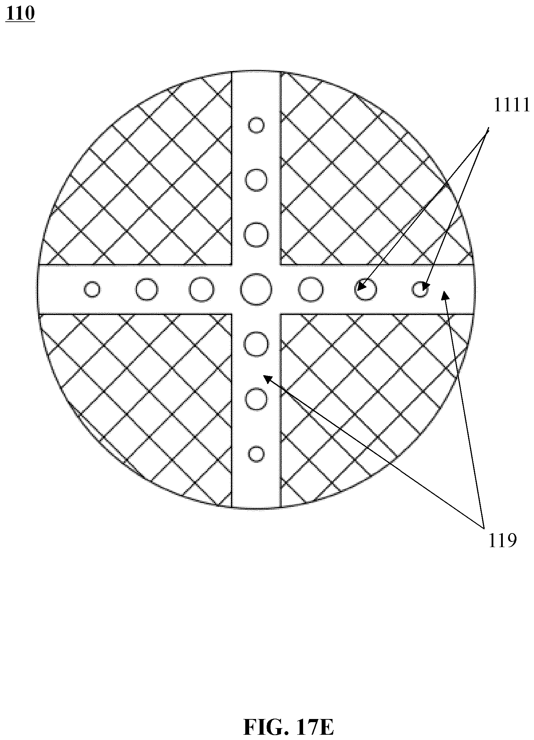

FIG. 16 is a schematic diagram illustrating an exemplary crystal preparation apparatus according to some embodiments of the present disclosure. FIG. 17A is a side view of an exemplary seed crystal support according to some embodiments of the present disclosure. FIG. 17B is a side view of another exemplary seed crystal support according to some embodiments of the present disclosure. FIG. 17C is a top view of a cross section of an exemplary seed crystal support according to some embodiments of the present disclosure. FIG. 17D is a top view of a cross section of an exemplary seed crystal support according to yet another embodiment of the present disclosure. FIG. 17E is a top view of a cross section of an exemplary seed crystal support according to yet another embodiment of the present disclosure. The crystal preparation apparatus and the connecting device involved in the embodiments of the present disclosure may be described in detail in the following in connection with FIG. 16 and FIG. 17A- FIG. 17E. It should be noted that the following embodiments are only for explaining the present disclosure and do not constitute a limitation of the present disclosure.

In some embodiments, a crystal preparation apparatus 10 may prepare a crystal (e.g., a silicon carbide crystal, an aluminum nitride crystal, a zinc oxide crystal, a zinc antimonide crystal, or the like) based on a solution manner (e.g., liquid phase epitaxy). In some embodiments, as shown in FIG. 16, the crystal preparation apparatus 10 may include a connecting device 100, a growth cavity 200, and a heating assembly (not shown in the figure).

The growth cavity 200 may be configured to place a source material 220. In some embodiments, the source material 220 may be disposed within the growth cavity 200 (e.g., a lower middle portion of the cavity). For example, in the case of growing silicon carbide crystals, the growth cavity 200 may be a graphite crucible and the source material 220 may be silicon.

The connecting device 100 may be configured to support a seed crystal B. In some embodiments, the seed crystal B may be fixedly adhered to the bottom of the connecting device 100 (e.g., at the center of a lower surface of the connecting device 100).

The heating assembly may be configured to heat the growth cavity 200. In some embodiments, the heating assembly may heat the growth cavity 200 to melt the source material 220 placed therein into a molten liquid state. In some embodiments, the source material 220 may be provided on (e.g., surrounded by) an exterior of the growth cavity 200 and/or a bottom of the growth cavity 200. In some embodiments, the heating assembly may include an induction heating assembly, a resistance heating assembly, or the like.

In some embodiments, the crystal preparation device 10 may also include a motion assembly (not shown in the figures). The motion assembly may be configured to control the up and down motion of the connecting device 100. In some embodiments, the motion assembly may actuate the connecting device 100 downwardly to bring the seed crystal B into contact with the supersaturated source material in the molten liquid state, thereby growing crystals on the seed crystal B. In some embodiments, the motion assembly may be connected to an upper end of the connecting device 100. In some embodiments, the motion assembly may include a drive portion and a transmission portion. The transmission portion connects the drive portion and the connecting device 100, and drives the connecting device 100 up and down via the drive portion.

In some embodiments, the crystal preparation apparatus 10 may further include an insulation assembly for insulating the growth cavity 200. In some embodiments, the insulation assembly may be provided outside the growth cavity 200. In some embodiments, the insulation assembly may include one or more insulation layers. In some embodiments, a material of the insulation layers may include at least one of graphite felt, zirconia, alumina, carbon material, or carbon fiber material.

In some embodiments, the connecting device 100 may include a seed crystal rod 120 and a seed crystal support 110. The seed crystal support 110 is connected to a lower end of the seed crystal rod 120.

In some embodiments, the seed crystal rod 120 may be any regular or irregular shape such as a cylinder, a rectangle, a prismatic cylinder, or the like. In some embodiments, the lower end of the seed crystal rod 120 may be fixedly connected (e.g., snap-fit, bonded) with the upper end of the seed crystal support 110. In some embodiments, a concave hole (e.g., a vertical through hole) may be provided above the seed crystal support 110 through which the seed crystal rod 120 may be connected to the seed crystal support 110. For example, an external thread may be provided at a bottom of the seed crystal rod 120, and an internal thread matching with the external thread may be provided in the concave hole, which accordingly enables a threaded connection between the seed crystal rod 120 and the seed crystal support 110. In some embodiments, the seed crystal rod 120 may be a hollow structure to appropriately improve heat dissipation near the seed crystal B, thereby improving the growth surface (e.g., surface convexity) of the prepared crystals and enhancing the quality of the subsequently prepared crystals.

In some embodiments, the lower surface of the seed crystal support 110 may be provided as a flat surface for adhering the seed crystal. In some embodiments, the shape of the lower surface of the seed crystal support 110 may be any regular or irregular shape such as round, square, triangular, or the like. In some embodiments, the seed crystal support 110 may include at least a portion of a heat dissipation structure to appropriately improve heat dissipation near the seed crystal, thereby improving the growth surface (e.g., surface convexity) of the prepared crystals and enhancing the quality of the subsequently prepared crystals. In some embodiments, the heat dissipation structure may be provided on the upper surface of the seed crystal support 110 or on the seed crystal support 110. In some embodiments, the heat dissipation structure may be provided on the interior of the seed crystal support 110 or on the seed crystal support 110.

The heat dissipation structure of the seed crystal support covered by the embodiments of the present disclosure may be described in detail below in connection with FIG. 17A- FIG. 17E.

In some embodiments, the heat dissipation structure may include a stepped-raised structure 117 with a thicker center and a thinner edge, as shown in FIG. 17A. In some embodiments, dimensions of a plurality of stepped-raised structures 117 may be the same or different. In some embodiments, dimensions of the plurality of stepped-raised structures 117 refer to widths of steps, heights of the steps, etc., or any combination thereof. In some embodiments, a distance between two adjacent stepped-raised structures 117 may be the same or different.

The distance between the stepped-raised structures (e.g., the distance between the two adjacent stepped-raised structures), the widths of the steps and/or the heights of the steps affect a heat dissipation area, which in turn affects a heat dissipation capability of the seed crystal support, and thus the distance between the stepped-raised structures, the widths of the steps and/or the heights of the steps are required to meet certain requirements.

In some embodiments, the distance between the stepped-raised structures may be within a range of 5-20 mm. In some embodiments, the distance between the stepped-raised structures may be within a range of 6-19 mm. In some embodiments, the distance between the stepped-raised structures may be within a range of 7-18 mm. In some embodiments, the distance between the stepped-raised structures may be within a range of 8-17 mm. In some embodiments, the distance between the stepped-raised structures may be within a range of 9-16 mm. In some embodiments, the distance between the stepped-raised structures may be within a range of 10-15 mm. In some embodiments, the distance between the stepped-raised structures may be within a range of 11-14 mm. In some embodiments, the distance between the stepped-raised structures may be within a range of 12-13 mm.

In some embodiments, the widths of the steps may be within a range of 2-20 mm. In some embodiments, the widths of the steps may be within a range of3-18mm. In some embodiments, the widths of the steps may be within a range of 4-16mm. In some embodiments, the widths of the steps may be within a range of 5-15 mm. In some embodiments, the widths of the steps may be within a range of 7-13 mm. In some embodiments, the widths of the steps may be within a range of 9-12 mm. In some embodiments, the widths of the steps may be within a range of 10-11 mm.

In some embodiments, the heights of the steps may be within a range of 2-20 mm. In some embodiments, the heights of the steps may be within a range of 4-18mm. In some embodiments, the heights of the steps may be within a range of 5-15mm. In some embodiments, the heights of the steps may be within a range of 7-13mm. In some embodiments, the heights of the steps may be within a range of 10-12 mm.

By providing a heat dissipation structure with a stepped-raised structure with suitable distance, width, and/or height, a seed crystal support with a stepped-raised structure with a thick center and a thin edge may be formed, thereby allowing an increase in the heat dissipation area of the seed crystal support, an appropriate increase in the heat dissipation effect in the center region, an improvement in the growth surface (e.g., surface convexity) of the prepared crystals, and an improvement in the quality of the prepared crystals.

In some embodiments, as shown in FIG. 17B, the heat dissipation structure may include a conical-raised structure 118 with a high center and a low edge.

The height and/or the size of a conical angle of the conical raised structure may affect the heat dissipation area, which in turn affects the heat dissipation capability of the seed crystal support, and thus the height and/or the size of the conical angle of the conical raised structure needs to meet certain requirements.

In some embodiments, the height of the conical raised structure may be within a range of 5-200 mm. In some embodiments, the height of the conical raised structure may be within a range of 10-190 mm. In some embodiments, the height of the conical raised structure may be within a range of 30-180 mm. In some embodiments, the height of the conical raised structure may be within a range of 50-160 mm. In some embodiments, the height of the conical raised structure may be within a range of 70-150 mm. In some embodiments, the height of the conical raised structure may be within a range of 90-130 mm. In some embodiments, the height of the conical raised structure may be within a range of 100-120 mm.

In some embodiments, the conical angle of the conical raised structure may be within a range of 5°-175°. In some embodiments, the conical angle of the conical raised structure may be within a range of 10°-170°. In some embodiments, the conical angle of the conical raised structure may be within a range of 20°-160°. In some embodiments, the conical angle of the conical raised structure may be within a range of 30°-150°. In some embodiments, the conical angle of the conical raised structure may be within a range of 50°-130°. In some embodiments, the conical angle of the conical raised structure may be within a range of 70°-110°. In some embodiments, the conical angle of the conical raised structure may be within a range of 90°-100°.

By setting a heat dissipation structure with a conical raised structure of a suitable height and/or a conical angle, a seed crystal support with a conical raised structure with a high center and a low edge may be formed, so that the heat dissipation area of the seed crystal support may be increased and the heat dissipation in the center area may be appropriately improved. This enables the surface of the prepared crystals to have a regular morphology and a suitable convexity, to improve the quality of the prepared crystals.

In some embodiments, the heat dissipation structure may include at least one horizontal through hole 119 within the seed crystal support 110. For example, as shown in FIG. 17C, the heat dissipation structure may include two horizontal through holes 119 within the seed crystal support 110. In some embodiments, a plurality of horizontal through holes 119 may have the same or different dimensions. In some embodiments, the plurality of horizontal through holes 119 may be provided in the same horizontal plane or may be provided in different horizontal planes. In some embodiments, the plurality of horizontal through holes 119 may be provided in parallel or at cross.

In some embodiments, the seed crystal support 110 having the horizontal through hole 119 may be a cylinder (or disk) or may include the stepped-raised structure shown in FIG. 17A or the raised structure shown in FIG. 17B.

In some embodiments, a center vertical hole 1110 may be provided in an upper portion of the seed crystal support 110, and the seed crystal support 110 is connected (e.g., snapped, bonded, threaded) to the seed crystal rod 120 via the center vertical hole 1110. In some embodiments, the horizontal through hole 119 may be connected to the center vertical hole 1110 to further enhance heat dissipation.

In some embodiments, a switch assembly (not shown in FIG. 17C) may be provided on the horizontal through hole 119 to enable the size or count of the through hole to be dynamically controlled in real time to dynamically regulate heat dissipation capacity.

The dimension of the horizontal through hole (e.g., a side length or diameter of a cross-section of the through hole) affect the heat dissipation effect and thus the heat dissipation capacity of the seed crystal support. Thus, the dimension of the horizontal through hole needs to meet certain requirements.

In some embodiments, the dimension of the horizontal through hole 119 may be within a range of 0.01-10 mm. In some embodiments, the dimension of the horizontal through hole 119 may be within a range of 0.05-9.5 mm. In some embodiments, the dimension of the horizontal through hole 119 may be within a range of 0.1-9 mm. In some embodiments, the dimension of the horizontal through hole 119 may be within a range of 0.5-8.5 mm. In some embodiments, the dimension of the horizontal through hole 119 may be within a range of 1-8 mm. In some embodiments, the dimension of the horizontal through hole 119 may be within a range of 2-7 mm. In some embodiments, the dimension of the horizontal through hole 119 may be within a range of 3-6 mm. In some embodiments, the dimension of the horizontal through hole 119 may be within a range of 4-5 mm.

By providing a horizontal through hole of suitable size, and/or connecting the horizontal through hole to the center vertical hole, the temperature distribution adjustment of the seed crystal support in the axial and radial directions may be realized, the heat dissipation effect may be appropriately improved, the growth surface of the prepared crystals (e.g., the surface convexity) may be improved, and the quality of the prepared crystals may be improved.

In some embodiments, the heat dissipation structure may include at least one vertical through hole within the seed crystal support 110. For example, as shown in FIG. 17D, the heat dissipation structure may include 12 a vertical through hole 1111 within the seed crystal support 110. In some embodiments, a plurality of vertical through holes 1111 may be of the same size or may be different. In some embodiments, the plurality of vertical through holes 1111 may be disposed on the same horizontal line or on different horizontal lines. In some embodiments, positions of the plurality of vertical through holes 1111 may be randomly set.

In some embodiments, the seed crystal support 110 having the vertical through hole 1111 may be cylindrical (or a disk) or may include the stepped-raised structure shown in FIG. 17A or the raised structure shown in FIG. 17B. In some embodiments, the center vertical hole 1110 may be provided in an upper portion of the seed crystal support 110, and the seed crystal support 110 is connected (e.g., snapped, bonded, threaded) to the seed crystal rod 120 via the center vertical hole 1110.

The dimension of the vertical through hole (e.g., a side length or diameter of a cross-section of the through hole) affects the heat dissipation area and thus the heat dissipation capacity of the seed crystal support. Thus, the dimension of the vertical through hole needs to meet certain requirements.

In some embodiments, the dimension of the vertical through hole 1111 may be within a range of 0.01-10 mm. In some embodiments, the dimension of the vertical through hole 1111 may be within a range of 0.05-9.5 mm. In some embodiments, the dimension of the vertical through hole 1111 may be within a range of 0.1-9 mm. In some embodiments, the dimension of the vertical through hole 1111 may be within a range of 0.5-8.5 mm. In some embodiments, the dimension of the vertical through hole 1111 may be within a range of 1-8 mm. In some embodiments, the dimension of the vertical through hole 1111 may be within a range of 2-7 mm. In some embodiments, the dimension of the vertical through hole 1111 may be within a range of 3-6 mm. In some embodiments, the dimension of the vertical through hole 1111 may be within a range of 4-5 mm.

In some embodiments, in order to appropriately improve the heat dissipation effect near the seed crystal to improve the surface morphology and convexity of the prepared crystals, and to improve the quality of the prepared crystals, the dimension of the vertical through hole near the center of the seed crystal support and the dimension of the vertical through hole near the edge of the seed crystal support may meet a certain requirement.

In some embodiments, the dimensions of the plurality of vertical through holes may be progressively reduced from the center to the edge of the seed crystal support 110. In some embodiments, a ratio of a diameter of a vertical through hole near the center of the seed crystal support to a diameter of the vertical through hole near an exterior or edge of the seed crystal support may be within a range of 5: 1-10: 1. In some embodiments, the ratio of the diameter of the vertical through hole near the center of the seed crystal support to the diameter of the vertical through hole near the exterior or edge of the seed crystal support may be within a range of 6:1-9:1. In some embodiments, the ratio of the diameter of the vertical through hole near the center of the seed crystal support to the diameter of the vertical through hole near the exterior or edge of the seed crystal support may be within a range of 7:1-8:1.

In some embodiments, an inert gas may be passed through the vertical through hole 1111 to improve heat dissipation. In some embodiments, the inert gas may be one or more of helium, argon, or neon.

In order to achieve a more suitable heat dissipation, a flow rate of the inert gas needs to meet a certain requirement.

In some embodiments, the flow rate of the inert gas may be within a range of 5-1000 mL/min. In some embodiments, the flow rate of the inert gas may be within a range of 10-950mL/min. In some embodiments, the flow rate of the inert gas may be within a range of 30-900mL/min. In some embodiments, the flow rate of the inert gas may be within a range of 50-850mL/min. In some embodiments, the flow rate of the inert gas may be within a range of 100-800mL/min. In some embodiments, the flow rate of the inert gas may be within a range of 150-750mL/min. In some embodiments, the flow rate of the inert gas may be within a range of 200-700mL/min. In some embodiments, the flow rate of the inert gas may be within a range of 250-650mL/min. In some embodiments, the flow rate of the inert gas may be within a range of 300-600mL/min. In some embodiments, the flow rate of the inert gas may be within a range of 350-550mL/min. In some embodiments, the flow rate of the inert gas may be within a range of 400-500mL/min. In some embodiments, the flow rate of the inert gas may be within a range of 450-480mL/min.

In some embodiments, a switch assembly (not shown in FIG. 17D) may be provided on the vertical through hole 1111 to enable dynamic real-time control of the dimension or count of the through hole to dynamically adjust the heat dissipation capacity.

By setting a vertical through hole with a suitable dimension and/or setting the dimension of the vertical through hole to gradually decrease from the center to the edge of the seed crystal support, it is possible to make the center region of the seed crystal support have a larger heat dissipation area, a larger air flow rate, and a better heat dissipation effect than the edge region, making the surface morphology of the crystals regular and the overall convexity of the crystals more appropriate.

In some embodiments, as shown in FIG. 17E, the heat dissipation structure may include at least one horizontal through hole 119 on the seed crystal support 110 and at least one vertical through hole 1111.

In some embodiments, the plurality of horizontal through holes 119 may be of the same dimension or may be different. In some embodiments, the plurality of horizontal through holes 119 may be provided in the same horizontal plane or may be provided in different horizontal planes. In some embodiments, the plurality of horizontal through holes 119 may be provided in parallel or at cross.

In some embodiments, dimensions of one or more vertical through holes 1111 may be the same or different. In some embodiments, the dimensions of the plurality of vertical through holes decrease from the center to the edge of the seed crystal support 110.

In some embodiments, the dimensions of the horizontal through hole 119 and the vertical through hole 1111 may be the same. In some embodiments, the dimensions of the horizontal through hole 119 and the vertical through hole 1111 may be different. In some embodiments, in order to provide dynamic real-time control of the dimension or count of the through hole to enable adjustment of the surface morphology and the convexity of the crystals, a switch assembly (not shown in FIG. 17E) may be provided on the horizontal through hole 119 and/or the vertical through hole 1111.

In some embodiments, at least one horizontal through hole 119 is connected to at least one vertical through hole 1111, thereby further appropriately enhancing heat dissipation effect.

In some embodiments, the seed crystal support 110 may be cylindrical (or a disk) or may be conical including the stepped-raised structure shown in FIG. 17A or the raised structure shown in FIG. 17B.

By providing a horizontal through hole and a vertical through hole and/or connecting the horizontal through hole and the vertical through hole, temperature distribution adjustment in the axial and radial directions of the seed crystal support may be realized, so that the heat dissipation effect is appropriately enhanced, the growth surface (e.g., the surface convexity) of the prepared crystal is improved, and the quality of the prepared crystal is improved.

In some embodiments, the heat dissipation structures shown in FIG. 17A-FIG. 17E, may be arbitrarily combined to achieve a more suitable heat dissipation effect. By providing a suitable heat dissipation structure on the connecting device 100 during the crystal growth process, control of the growth surface (e.g., the surface convexity) may be realized when the crystals are grown out on the seed crystal, thereby improving the quality of the prepared crystal.

The specific device structure and heat dissipation effect may be described in detail below by examples 1-4. It is to be noted that the reaction conditions, the reaction materials, and the dosage of the reaction materials in the embodiments are only intended to illustrate the heat dissipation effect of the connecting device, and do not limit the scope of protection of the present disclosure.

### Example 1

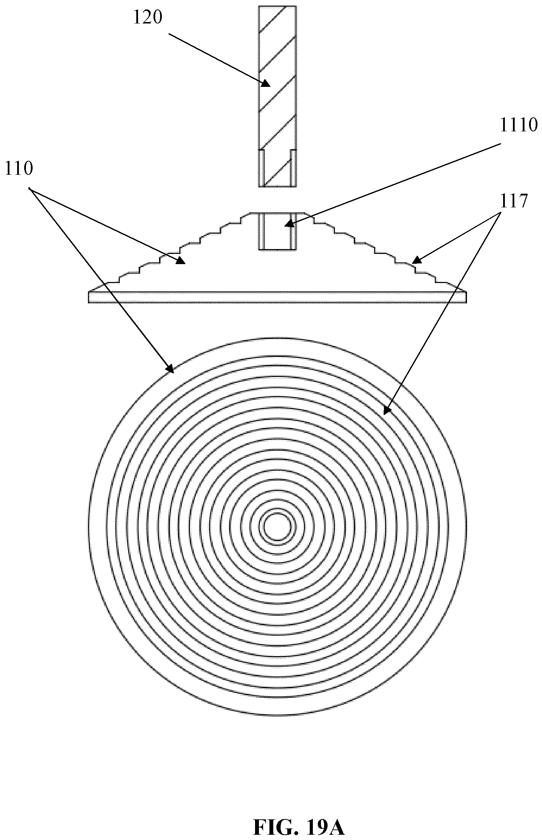

As shown in FIG. 19A, the connecting device 100 may include a seed crystal rod 120 and a seed crystal support 110. The seed crystal rod 120 is a solid structure, the upper surface of the seed crystal support 110 is a stepped-raised structure 117 with a thicker center and a thinner edge, and the seed crystal support 110 has a center vertical hole 1110 for mounting the seed crystal rod 120. Silicon carbide crystals are prepared using the connecting device.

Step 1, silicon and chromium alloy raw material is loaded in a graphite crucible with a diameter of 200 mm, and a height of 150 mm, and the weight of the silicon and chromium alloy raw material is 3956 g, a mass ratio of silicon and chromium is 84.2565:103.992, and the graphite crucible serves as a carbon source to provide the carbon necessary for preparing silicon carbide crystals; an upper edge of the graphite crucible is adjusted to be flush with an upper edge of an induction coil.

Step 2, the seed crystal B is bonded to a lower surface of the seed crystal support 110, and the seed crystal rod 120 is connected to the seed crystal support 110 through the center vertical hole 1110. The lower surface of the seed crystal support 110 is horizontal, the thickness of the seed crystal is 0.35 mm, and the seed crystal is bonded to the seed crystal support 110 with a special glue and is hot-pressed at a high temperature.

Step 3, the seed crystal is rotated and the oscillation of the seed crystal rod 120 is less than 1 mm.

Step 4, an insulation structure is installed, a furnace chamber is cleaned, a furnace body is sealed and evacuated to create a vacuum.

Step 5, the vacuum is drawn to 5.5×10-3Pa, then increase the temperature is increased at a rate of 1.5KW/h while continuing to evacuate. When the heating power rises to 6KW, the pressure is maintained at 5.5×10-3Pa, and the helium is charged to a pressure of 0.02Mpa after decreasing the heating power to 1KW. The heating power is raised to 6KW and then the temperature is raised to 1880°C at a rate of 2KW/h.

Step 6, after warming to 1880°C, the seed crystal is slowly dropped while adjusting the temperature, this process takes about 1 hour to complete, and then a constant temperature is maintained and the seed crystal rod 120 is begun to be lifted.

Step 7, during the crystal growth process, a rotational speed of the seed crystal rod 120 is maintained at 10 rpm throughout, a pulling speed is maintained at 0.2 mm/h throughout, a pressure is maintained at 0.02 Mpa throughout, and a growth temperature is maintained at 1700 °C throughout. The crystal growth process lasts for 30 hours.

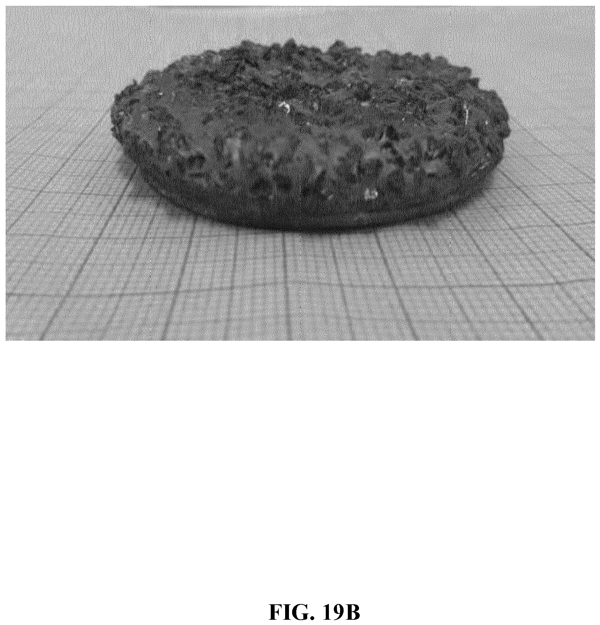

As shown in FIG.19B, the surface of the grown crystals is slightly convex, but not obvious, and the overall morphology of the surface is relatively regular, with slightly large polycrystalline particles interspersed with melt inclusions, and some smaller silicon carbide grains adhered.

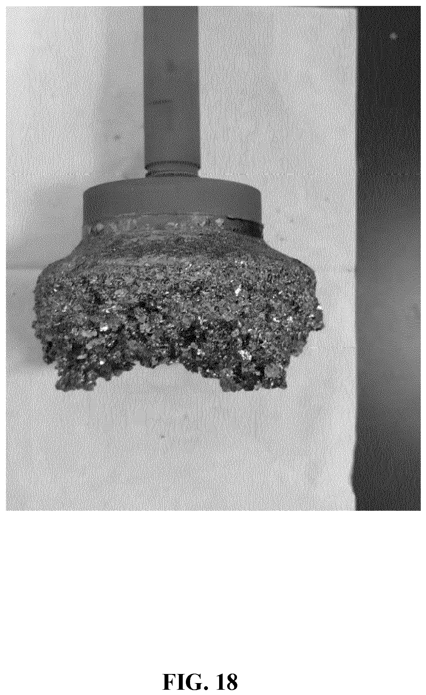

Compared with the crystals prepared using the conventional seed crystal support shown in FIG. 18, the use of the seed crystal support with the stepped-raised structure shown in FIG. 19A in example 1 has significantly improved structure and morphology, etc., of the entire growth surface of the crystals, and the convexity of the growth surface of the crystals is also improved.

### Example 2

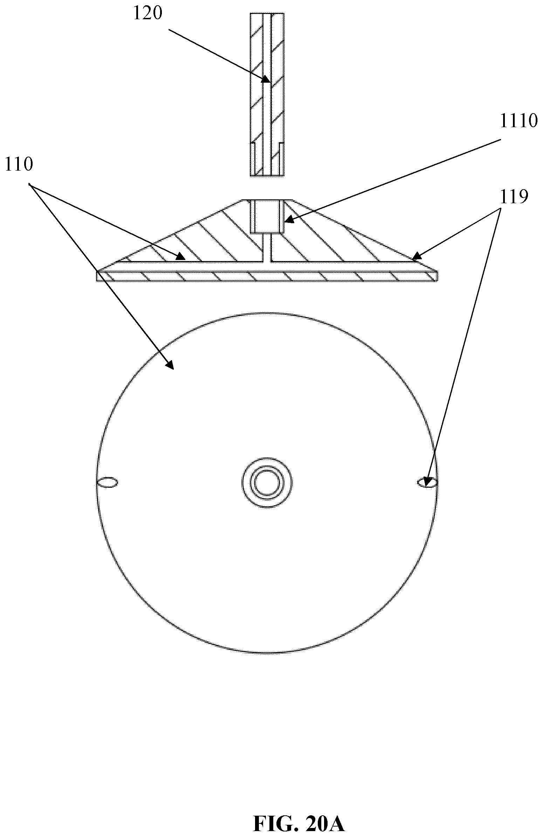

As shown in FIG. 20A, the connecting device 100 may include a seed crystal rod 120 and a seed crystal support 110. The seed crystal rod 120 is a hollow structure, the seed crystal support 110 is a conical raised structure with a high center and a low edge. The seed crystal support 110 has a center vertical hole 1110 and a horizontal through hole 119. The center vertical hole 1110 is configured to install the seed crystal rod 120, and the center vertical hole 1110 and the horizontal through hole 119 are connected. Silicon carbide crystals are prepared using the connecting device.

Step 1, silicon and chromium alloy raw material is loaded in a graphite crucible with a diameter of 200 mm, a height of 150 mm, and a weight of 3956 g, a mass ratio of silicon and chromium is 84.2565:103.992, and the graphite crucible serves as a carbon source to provide the carbon necessary for preparing silicon carbide crystals; a distance from the surface of the material to the mouth of the graphite crucible is within a range of 40-50mm, and the upper edge of the graphite crucible is adjusted to be flush with the upper edge of an induction coil.

Step 2, a seed crystal is bonded to the lower surface of the seed crystal support 110 as shown in FIG. 20A. The seed crystal rod 120 is mounted to the center vertical hole 1110 of the seed crystal support 110. The lower surface of the seed crystal support 110 is horizontal, the thickness of the seed crystal is 0.5 mm, and the seed crystal is bonded to the seed crystal support 110 with a special glue and is hot-pressed at a high temperature.

Step 3, the seed crystal is rotated so that the oscillation of the seed crystal rod 120 is less than 1 mm.

Step 4, a distance from the seed crystal to the surface of the material is within a range of 30-40mm, an insulation structure is installed, a furnace chamber is cleaned, a furnace body is sealed, and a vacuum is created by evacuation.

Step 5, after the vacuum is drawn to 5.5×10-3 Pa, helium is charged to 0.02 MPa, and then the temperature is raised to 1880°C at a rate of 2000 W/h.

Step 6, after heating to 1880°C, the seed crystal slowly dropped while adjusting the temperature, this process takes about 5 hours to complete, and then a constant temperature is maintained and the seed crystal rod 120 is begun to be lifted.

Step 7, during the crystal growth process, the rotational speed of the seed crystal rod 120 is maintained at 20 rpm throughout, the pulling speed is maintained at 0.1 mm/h throughout, the pressure is maintained at 0.02 MPa throughout, and the growth temperature is maintained at 1880° C. The crystal growth process lasts for 120 hours.

Step 8, after the crystal growth process is finished, the crystal is pulled away from the liquid surface at a faster pulling speed, a cooling process is started under a cooling rate of 1000°C/h or less; when the heating power is reduced to 500W or less, the heating assembly is turned off, and the crystals are removed after the temperature is reduced to room temperature.

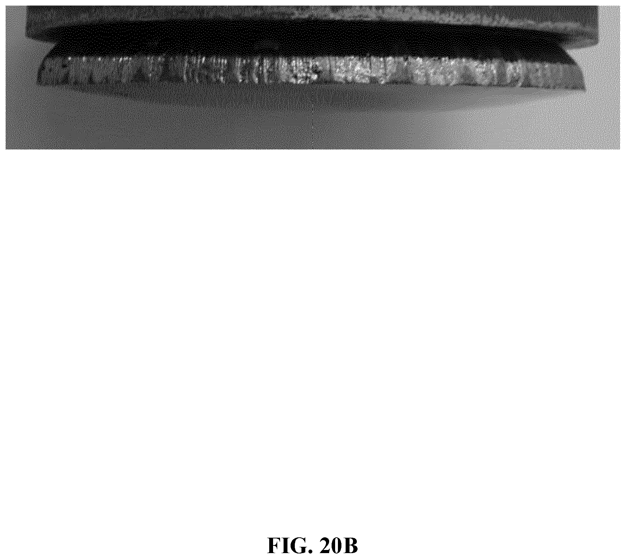

As shown in FIG. 20B, the grown crystal has a certain convexity, with a convexity value of 3.86 mm, and a relatively regular and smooth surface.

Compared with the crystals prepared using the conventional seed crystal support shown in FIG. 18, the use of the seed crystal support with a central vertical hole, a horizontal through hole, and a conical raised structure shown in FIG. 20A in example 2 has a better adjusting effect on the surface morphology and convexity of the crystals.

### Example 3

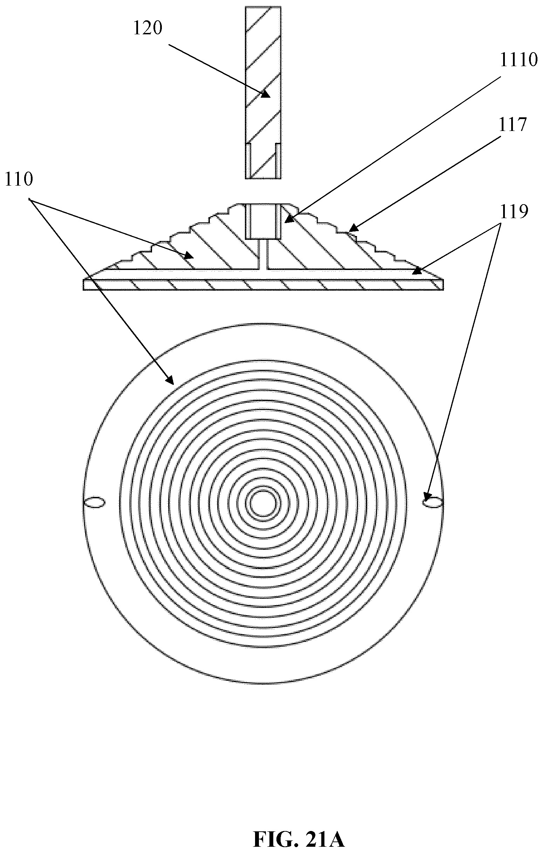

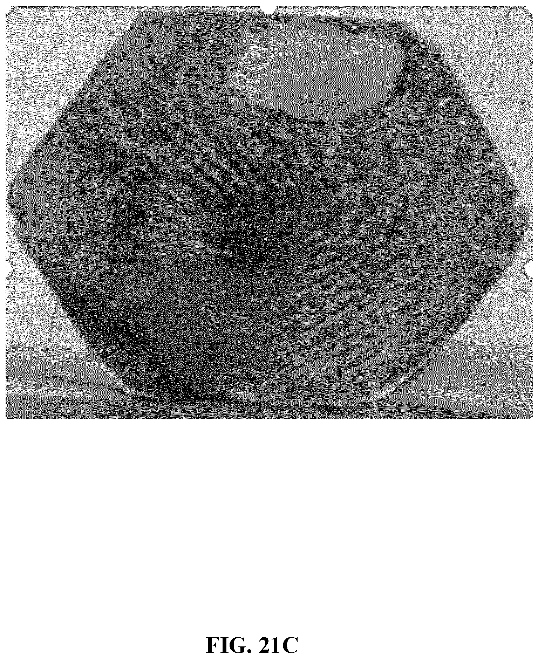

As shown in FIG. 21A, the connecting device 100 may include a seed crystal rod 120 and a seed crystal support 110. The seed crystal rod 120 is a hollow structure. The upper surface of the seed crystal support 110 is a stepped-raised structure 117 with a thick center and a thin edge. The seed crystal support 110 has a center vertical hole 1110 and a horizontal through hole 119. The center vertical hole 1110 is configured to mount the seed crystal rod 120, and the center vertical hole 1110 is connected with the horizontal through hole 119. The connecting device 100 shown in FIG. 21A is equivalent to a combination of the connecting device shown in FIG. 19A and the connecting device shown in FIG. 20A. Silicon carbide crystals are prepared using this connecting device.

Step 1, 5kg-6kg of chromium silicide raw material are weighed and put into a graphite crucible weighing 3955g, a mass ratio of silicon and chromium is 84.2565:103.992, and the graphite crucible serves as a carbon source to provide the carbon necessary for preparing the silicon carbide crystals; a distance from the surface of the material to the upper edge of the crucible is within a range of 10-15mm.

Step 2, a seed crystal is bonded to the lower surface of the seed crystal support 110 as shown in FIG. 21A. The seed crystal rod 120 is mounted to the center vertical hole 1110 of the seed crystal support 110, and the seed crystal support 110 with bonded seed crystal is connected with the growth chamber, ensuring that the connection is tight; the lower surface of the seed crystal support 110 is horizontal, the thickness of the seed crystals is 1 mm, and the seed crystal and the seed crystal support 110 are bonded with a special glue and is hot-pressed at a high temperature.

Step 3, the assembled hot field (including crucible and connecting device) is put together into the furnace chamber and the furnace body is sealed.

Step 4, the furnace body is evacuated to create a vacuum according to the operating procedure of the vacuum system, and after the vacuum degree reaches 5×10-3 Pa, the heating assembly is turned on, and the induction coil is used for heating.

Step 5, after the true evacuation is completed, a certain amount of helium is charged into the furnace, and the seed crystal is put down after reaching the set temperature of 2000°C and completely melting the raw material.

Step 6, after the seed crystal is in contact with the raw material, the movement of the connecting device is controlled according to the rotational speed of 30 rpm and the pulling speed within a range of 0.05 mm/h-0.15 mm/h to start the growth process at a constant temperature.

Step 7, after the crystal is grown to a weight of 695.2 g, the crystal is lifted to about 10 mm away from the interface and started to cool down.

Step 8, the crystal is removed when the temperature drops to the room temperature.

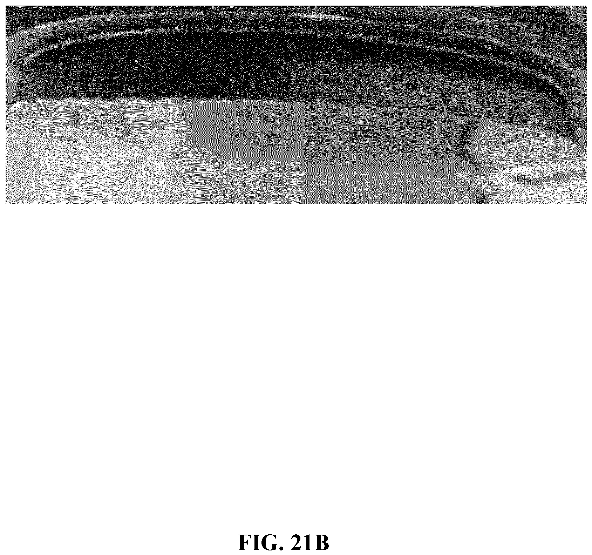

As shown in FIG.21B- FIG.21C, the grown crystal has a certain convexity, with a value of 3.91 mm, and the surface morphology is regular and smooth. Compared with the crystals prepared using the conventional seed crystal support as shown in FIG.18, the seed crystal support with the center vertical hole, the horizontal through hole, and the stepped-raised structure as shown in FIG.21A in example 3 has a significant effect on the surface morphology and convexity of the crystals.

As may be seen from the results of examples 2 and 3, by increasing the heat dissipation area through the stepped-raised structure, and at the same time dissipating the heat and ventilating through the center vertical hole and the horizontal through hole, the temperature gradient at different locations of the crystal may be adjusted, thereby controlling the surface morphology and convexity of the crystal. Thus, the surface morphology and convexity of the grown crystal are improved.

### Example 4

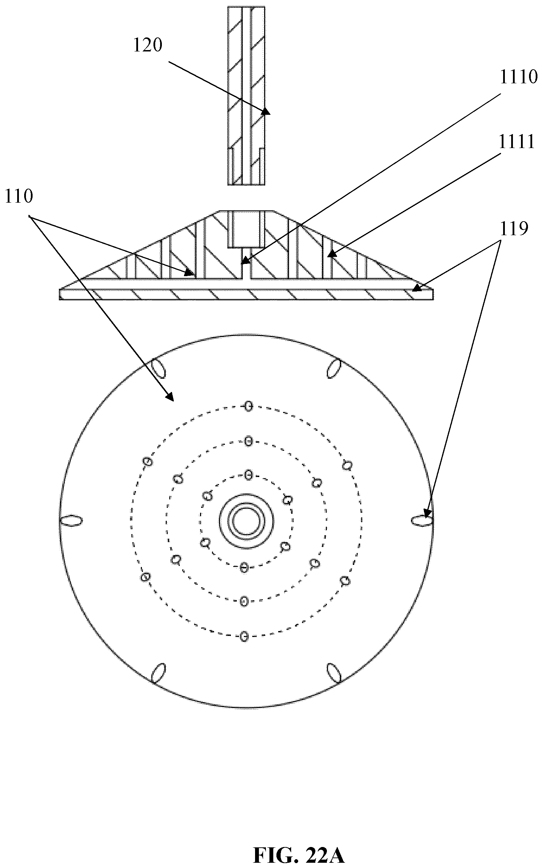

As shown in FIG. 22A, the connecting device 100 may include a seed crystal rod 120 and a seed crystal support 110. The seed crystal rod 120 is a hollow structure and the seed crystal support 110 is a conical raised structure with a high center and a low edge. The seed crystal support 110 has a center vertical hole 1110, a plurality of vertical through holes 1111, and a plurality of horizontal through holes 119. The center vertical hole 1110 is configured to install the seed crystal rod 120, the plurality of horizontal through holes 119 are in the same horizontal plane and intersect at a center of a control panel, the center vertical hole 1110 and the horizontal through hole 119 are connected, and the plurality of vertical through holes 1111 and the plurality of horizontal through holes 119 are vertically distributed and connected. The connecting device 100 shown in FIG. 21A is equivalent to a combination of the connecting device shown in FIG. 19A and the connecting device shown in FIG. 20A. Silicon carbide crystals are prepared using this connecting device.

Step 1, a certain amount of graphite insulation is put inside an induction coil in a vacuum chamber.

Step 2, a certain proportion of raw materials (flux and silicon) weighing 1500g is put into the graphite crucible, a mass ratio of silicon and chromium is 84.2565:103.992, and the graphite crucible serves as a carbon source to provide the carbon necessary for preparing the silicon carbide crystals.

Step 3, the seed crystal is bonded to the lower surface of the seed crystal support 110 as shown in FIG. 22A. The lower surface of the seed crystal support 110 is horizontal, the thickness of the seed crystals is 0.5 mm, and the seed crystal and the seed crystal support 110 are bonded with a special glue and is hot-pressed at a high temperature. The seed crystal rod 120 is mounted to the center vertical hole 1110 of the seed crystal support 110.

Step 4, after sealing the furnace chamber, the vacuum pump is turned on, the pressure in the furnace is pumped to below 5.5×10-3 Pa, and a certain amount of argon is charged to the pressure of 0.04 MPa; the crucible in the furnace is heated.

Step 5, after a flux-containing solution is melted, the seed crystal is lowered to about 3-5 mm above the liquid surface of the raw material, with a preheating time of 3h, and then the seed crystal continues to be lowered until the seed crystal is in contact with the liquid surface.

Step 6, according to the rotational speed of 30rpm and the pulling speed of 0.1mm/h, the movement of the connecting device is begun to be controlled, the temperature is maintained at 1950°C, and the rotational speed is maintained constant.

Step 7, after the crystal growth is finished, the crystal is pulled away from the liquid surface and the cooling process is started; the crystal is removed after the temperature is reduced to the room temperature.

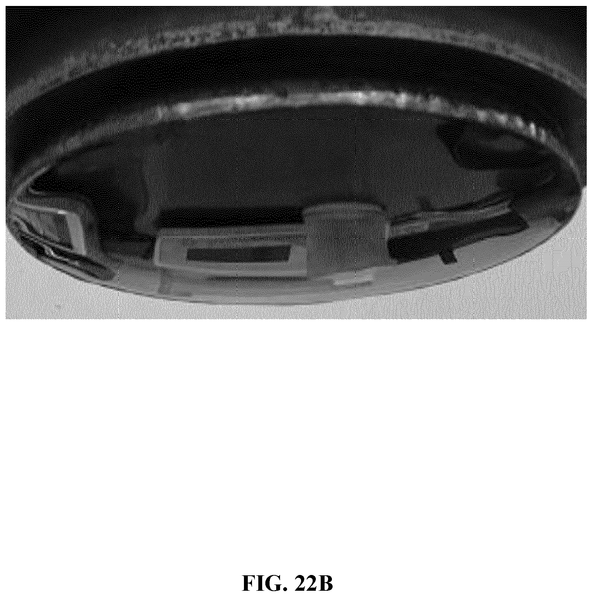

As shown in FIG. 22B, the convexity of the center and edge of the grown crystal are appropriate, with a convexity value of 4.85 mm, and the whole surface of the crystal is an extremely smooth sphere.

Compared with the crystal prepared using the conventional seed crystal support shown in FIG. 18, using the seed crystal support shown in FIG. 22A in example 4 with the center vertical hole, the plurality of vertical through holes, the plurality of horizontal through holes, and the conical raised structure increases the heat dissipation in the center of the crystal, increases the temperature gradient in the center of the crystal, and increases the longitudinal gradient within the temperature field, thereby significantly improving the surface morphology and convexity of the crystal.

As may be seen from the above examples 1-4, by means of the heat dissipation structure shown in the embodiments of the present disclosure, it is possible to realize effective control of the surface morphology and convexity of the crystal, and thus to improve the quality of the crystal.

In some embodiments, the embodiments described above may be combined in any combination. For example, the connecting device 100 may include both a leveling assembly 130 and a protection assembly 140. Before growing the crystal, the leveling assembly 130 is utilized to adjust the seed crystal rod 120 and the seed crystal support 110 until the proper position. The positionally adjusted seed crystal support 110 is protected using the protection assembly 140 during crystal growth. As another example, the seed crystal support 110 may include both the stepped-raised structure 117 and the protection assembly 140, and an inner surface of the protection assembly 140 may be provided with a stepped surface that cooperates with the stepped-raised structure 117. As yet another example, the seed crystal support 110 may simultaneously include the horizontal through hole 119, the vertical through hole 1111, and the protection assembly 140. The protection assembly 140 may be provided with through holes that are connected with the horizontal through hole 119 and the vertical through hole 1111, respectively. As yet another example, the seed crystal support 110 includes a cylindrical portion 112 and a truncated cone portion 113. The truncated cone portion 113 may be provided with a connection block 116, and the connection block 116 may be provided on the upper surface and/or the side of the truncated cone portion 113.

The embodiments of the present disclosure may include, but are not limited to the following beneficial effects. First, the utilization of an adjustment assembly may quickly level the seed crystal rod, so that the axes of the seed crystal rod, the seed crystal support, and the crucible are kept in coincidence, to eliminate the device error and ensure the growth quality of the crystal. Second, the adjustment assembly may be used at an arbitrary point within the sphere, so as to improve the flexibility and precision of the adjustment. Third, the utilization of the protection assembly may prevent the phenomenon of material crawling, avoiding the upper surface and/or the side surface of the seed crystal support from contacting with the gas phase composition and causing the upper surface and/or the side surface to crystallize, and avoiding the upper surface and/or the side surface from crystallizing and affecting the removal of crystals. Fourth, the connection point connecting the seed crystal support and the at least one seed crystal rod does not coincide with the rotation center of the seed crystal support, so that when the transmission assembly drives the at least one seed crystal rod to rotate and thereby drives the seed crystal support to rotate, the rotation of the seed crystal support may not cause the connection between the at least one seed crystal rod and the seed crystal support to loosen. The count of the connection point is greater than or equal to 2, which may ensure the stable and solid connection of the seed crystal support, and thus ensure the normal growth of the crystals. Fifth, the connection points connecting the seed crystal support and the at least one seed crystal rod are uniformly distributed along the periphery of the seed crystal support, which may ensure that the connection between the at least one seed crystal rod and the seed crystal support is stable, so as to put the seed crystal support in a smooth state, which in turn ensures normal crystal growth. Sixth, by providing the heat dissipation structure (e.g., the stepped-raised structure or the conical raised structure) on the upper surface of the seed crystal support, and/or by providing the horizontal through hole and/or the vertical through hole inside the seed crystal support, the temperature distribution in the axial direction and the radial direction of the seed crystal support may be adjusted, and the heat dissipation capacity of each position of the seed crystal support may be changed, and the surface morphology and the convexity of the crystal is then adjusted. Seventh, through the design of the dimension of the steps and/or the dimension of the through hole, the crystal surface morphology and convexity may be controlled effectively. Eighth, through the connection between the horizontal through hole and the vertical through hole, the heat dissipation effect may be improved appropriately, and thus a better regulation of the surface morphology and convexity of the crystals may be realized. Ninth, through the installation of the switch assembly on the horizontal through hole or the vertical through hole, the dimensions or the count of the horizontal through hole or the vertical through hole may be dynamically controlled in real-time to realize the adjustment of the surface morphology and convexity of the crystals. It should be noted that the beneficial effects that may be produced by different embodiments are different, and the beneficial effects that may be produced in different embodiments may be any one or a combination thereof, or any other beneficial effect that may be obtained.

Having thus described the basic concepts, it may be rather apparent to those skilled in the art after reading this detailed disclosure that the foregoing detailed disclosure is intended to be presented by way of example only and is not limiting. Although not explicitly stated here, those skilled in the art may make various modifications, improvements, and amendments to the present disclosure. These alterations, improvements, and amendments are intended to be suggested by this disclosure and are within the spirit and scope of the exemplary embodiments of the present disclosure.

Moreover, certain terminology has been used to describe embodiments of the present disclosure. For example, the terms "one embodiment," "an embodiment," and/or "some embodiments" mean that a particular feature, structure, or feature described in connection with the embodiment is included in at least one embodiment of the present disclosure. Therefore, it is emphasized and should be appreciated that two or more references to "an embodiment", "one embodiment", or "an alternative embodiment" in various portions of the present disclosure are not necessarily all referring to the same embodiment. In addition, some features, structures, or characteristics of one or more embodiments in the present disclosure may be properly combined.

Furthermore, the recited order of processing elements or sequences, or the use of numbers, letters, or other designations, therefore, is not intended to limit the claimed processes and methods to any order except as may be specified in the claims. Although the above disclosure discusses some embodiments of the invention currently considered useful by various examples, it should be understood that such details are for illustrative purposes only, and the additional claims are not limited to the disclosed embodiments. Instead, the claims are intended to cover all combinations of corrections and equivalents consistent with the substance and scope of the embodiments of the present disclosure. For example, although the implementation of various components described above may be embodied in a hardware device, it may also be implemented as a software only solution, e.g., an installation on an existing server or mobile device.

Similarly, it should be appreciated that in the foregoing description of embodiments of the present disclosure, various features are sometimes grouped together in a single embodiment, figure, or description thereof for the purpose of streamlining the disclosure aiding in the understanding of one or more of the various embodiments. However, this disclosure does not mean that object of the present disclosure requires more features than the features mentioned in the claims. Rather, claimed subject matter may lie in less than all features of a single foregoing disclosed embodiment.

In some embodiments, the numbers expressing quantities or properties used to describe and claim certain embodiments of the present disclosure are to be understood as being modified in some instances by the term "about", "approximate", or "substantially". For example, "about", "approximate", or "substantially" may indicate ±20% variation of the value it describes, unless otherwise stated. Accordingly, in some embodiments, the numerical parameters set forth in the written description and attached claims are approximations that may vary depending upon the desired properties sought to be obtained by a particular embodiment. In some embodiments, the numerical parameters should be construed in light of the number of reported significant digits and by applying ordinary rounding techniques. Notwithstanding that the numerical ranges and parameters setting forth the broad scope of some embodiments of the present disclosure are approximations, the numerical values set forth in the specific examples are reported as precisely as practicable.

Each of the patents, patent applications, publications of patent applications, and other material, such as articles, books, specifications, publications, documents, things, and/or the like, referenced herein is hereby incorporated herein by this reference in its entirety for all purposes. History application documents that are inconsistent or conflictive with the contents of the present disclosure are excluded, as well as documents (currently or subsequently appended to the present specification) limiting the broadest scope of the claims of the present disclosure. By way of example, should there be any inconsistency or conflict between the description, definition, and/or the use of a term associated with any of the incorporated material and that associated with the present document, the description, definition, and/or the use of the term in the present document shall prevail.

In closing, it is to be understood that the embodiments of the present disclosure disclosed herein are illustrative of the principles of the embodiments of the present disclosure. Other modifications that may be employed may be within the scope of the present disclosure. Thus, by way of example, but not of limitation, alternative configurations of the embodiments of the present disclosure may be utilized in accordance with the teachings herein. Accordingly, embodiments of the present disclosure are not limited to that precisely as shown and described.

## Claims

1. A connecting device for growing crystals in a liquid phase, comprising a seed crystal support and a seed crystal rod, wherein the seed crystal support is connected to one end of the seed crystal rod.

2. The connecting device of claim 1, further comprising a leveling assembly, wherein the leveling assembly is connected to another end of the seed crystal rod for leveling the seed crystal rod; and
the leveling assembly includes a supporting member, a connecting member, and an adjusting locking member, wherein
the connecting member is movably disposed on the supporting member, and one end of the connecting member is connected to another end of the seed crystal rod; and
the adjusting locking member is disposed on the supporting member for adjusting and locking a position of the connecting member relative to the supporting member.

3. The connecting device of claim 2, wherein the connecting member includes a connecting sphere and an adjusting sphere, wherein
the connecting sphere is movably abutted against the supporting member; and
the adjusting locking member contacts the adjusting sphere.

4. The connecting device of claim 3, wherein the adjusting locking member includes an upper locking block, an adjusting lever, and a locking lever, wherein
the upper locking block is provided above the adjusting sphere for applying a locking force that is vertical downward to the connecting member; and
the adjusting lever and the locking lever are disposed opposite each other on two sides of the adjusting sphere and contact a surface of the adjusting sphere.

5. The connecting device of claim 4, wherein the adjusting sphere includes an upper hemisphere and a lower hemisphere, and the adjusting lever and the locking lever contact the upper hemisphere and the lower hemisphere, respectively.

6. The connecting device of claim 5, wherein the upper hemisphere and the lower hemisphere have different diameters.

7. The connecting device of claim 4, wherein the adjusting locking member further includes an annular guide rail, an annular slider, an adjusting lever pillar and a locking lever pillar, wherein
the annular guide rail is provided on the supporting member, and the annular slider is capable of rotating relative to the annular guide rail by cooperating with the annular guide rail; and
the adjusting lever is provided on the adjusting lever pillar, the locking lever is set on the locking lever pillar, and the adjusting lever pillar and the locking lever pillar are provided opposite each other on the annular slider.

8. The connecting device of claim 4, wherein at least one of the adjusting lever or the locking lever is in a line contact or a surface contact with the adjusting sphere.

9. The connecting device of claim 1, further comprising a protection assembly, wherein the protection assembly is connected to the seed crystal support and covers an edge and an upper surface of the seed crystal support.

10. The connecting device of claim 9, wherein the seed crystal support includes a cylindrical portion and a truncated cone portion connected with the cylindrical portion.

11. The connecting device of claim 10, wherein the protection assembly includes an annular portion, a connecting portion, and a fixing portion, the fixing portion is provided in the connecting portion, and the annular portion is provided at an edge of the connecting portion;
the annular portion contacts an outer periphery of the cylindrical portion; and
the connecting portion contacts an outer periphery and an upper surface of the truncated cone portion.

12. The connecting device of claim 11, wherein
the one end of the seed crystal support includes an external thread; and
the fixing portion includes a first internal thread that mates with the internal thread.

13. The connecting device of claim 12, wherein the seed crystal support is provided with a second internal thread that mates with the external thread, and the one end of the seed crystal rod is threadedly connected to the seed crystal support and the fixing portion.

14. The connecting device of claim 13, wherein
the protection assembly further includes a key, and
a keyway that fits into the key is provided on the seed crystal support and the fixing portion.

15. The connecting device of claim 11, wherein the annular portion is provided with a chamfer.

16. The connecting device of claim 11, wherein a thickness of the connecting portion near a center of the connecting portion is greater than a thickness of an edge portion of the connecting portion.

17. The connecting device of claim 11, wherein materials of the annular portion and the connecting portion are boron nitride.

18. The connecting device of claim 1, wherein
a count of the seed crystal rod is at least one, a count of connection points connecting the at least one seed crystal rod and the seed crystal support is greater than or equal to 2, and the connection points do not coincide with a rotation center of the seed crystal support.

19. The connecting device of claim 18, wherein the connection points are uniformly distributed along a circumference of the seed crystal support.

20. The connecting device of claim 18, wherein the seed crystal support is in a slot connection with the at least one seed crystal rod.

21. The connecting device of claim 20, wherein the slot connection includes a connecting block and a connecting groove adapted to the connecting block, wherein
the connecting groove is provided on the seed crystal rod, and
the connecting block is provided on the seed crystal support.

22. The connecting device of claim 21, wherein the connecting device further includes a connecting ring, and the connecting ring is threadedly connected to the seed crystal rod provided with the connecting groove.

23. The connecting device of claim 18, wherein the seed crystal support is in a threaded connection with the at least one seed crystal rod.

24. The connecting device of claim 18, wherein the seed crystal support is connected to at least two seed crystal rods.

25. The connecting device of claim 18, wherein the seed crystal support is connected to one seed crystal rod via at least two connecting pins.

26. The connecting device of claim 25, wherein one of the at least two connecting pins include a connecting groove and a connecting ring, wherein
the connecting groove is mutually adapted with a connecting block provided on the seed crystal support, and
the connecting ring is connected to an outer wall of the one of the at least two connecting pins by threads.

27. The connecting device of claim 18, wherein the at least one seed crystal rod includes a plurality of connecting segments, and connection points between the plurality of the connecting segments does not coincide with a rotation center of the seed crystal support.

28. The connecting device of claim 1, wherein
the seed crystal support includes at least a portion of a heat dissipation structure.

29. The connecting device of claim 28, wherein the heat dissipation structure includes a stepped-raised structure with a thick center and thin edges.

30. The connecting device of claim 28, wherein the heat dissipation structure includes a conical raised structure with a high center and low edges.

31. The connecting device of claim 28, wherein the heat dissipation structure includes at least one horizontal through hole within the seed crystal support.

32. The connecting device of claim 31, wherein
the seed crystal support is connected to the seed crystal rod through a center vertical hole, and
the at least one horizontal through hole is connected to the center vertical hole.

33. The connecting device of claim 28, wherein the heat dissipation structure includes at least one vertical through hole within the seed crystal support.

34. The connecting device of claim 33, wherein a size of the at least one vertical through hole decreases progressively from a center to edges of the seed crystal support.

35. The connecting device of claim 28, wherein the heat dissipation structure includes at least one horizontal through hole and at least one vertical through hole within the seed crystal support.

36. The connecting device of claim 35, wherein the at least one horizontal through hole is connected to the at least one vertical through hole.

37. The connecting device of claim 28, wherein the seed crystal rod is a hollow structure.
